## Europäisches Patentamt

## European Patent Office

## Office européen des brevets

(19)

(11) Numéro de publication: **0 078 581**
**B1**

# FASCICULE DE BREVET EUROPEEN

(12)

(45) Date de publication du fascicule du brevet.
**19.03.86**

(21) Numéro de dépôt: **82201369.4**

(22) Date de dépôt. **01.11.82**

(51) Int. Cl.⁴ **H 04 B 14/06**

(54) **Système de transmission MIC-différentiel avec prédiction adaptative.**

(30) Priorité: **04.11.81 FR 8120676**

(43) Date de publication de la demande.
**11.05.83 Bulletin 83/19**

(45) Mention de la délivrance du brevet
**19.03.86 Bulletin 86/12**

(84) Etats contractants désignés
**BE DE FR GB IT SE**

(56) Documents cités
**EP - A - 0 024 243**
**AU - A - 72 806**
**FR - A - 2 481 026**

**IEEE TRANSACTIONS ON ACOUSTICS, SPEECH AND SIGNAL PROCESSING, vol. ASSP-29, no. 3, juin 1981, pages 337-341, IEEE, New York (USA); CUMHUR C.EVIC et al.: "DPCM-AOF using second-order adaptive predictors for speech signals"**
**NACHRICHTENTECHNISCHE ZEITSCHRIFT, vol. 24, no. 1, janvier 1971, pages 18-24, Braunschweig (DE); V. MOHRMANN: "Einige Verfahren uir adaptiven Einstellung von Entzerrern für die schnelle Datenübertragung"**

(73) Titulaire **TELECOMMUNICATIONS RADIOELECTRIQUES ET TELEPHONIQUES T.R.T., 88, rue Brillat Savarin, F-75013 Paris (FR)**

(72) Inventeur **Raulin, Jean Marie, SOCIETE CIVILE S.P.I.D. 209 rue de l'Université, F-75007 Paris (FR)**
Inventeur **Bonnerot, Georges, SOCIETE CIVILE S.P.I.D. 209 rue de l'Université, F-75007 Paris (FR)**

(74) Mandataire. **Chaffraix, Jean et al, Société Civile S.P.I.D. 209, rue de l'Université, F-75007 Paris (FR)**

## Description

L'invention concerne un système de transmission numérique d'informations utilisant la modulation différentielle par codage d'impulsions et comportant un codeur destiné à convertir un signal MIC linéaire entrant en un signal MIC différentiel et un décodeur distant destiné à effectuer la conversion inverse, le codeur comportant un circuit de différence formant le signal de différence entre le signal MIC linéaire entrant et un signal de prédiction, un quantificateur quantifiant le signal de différence pour former le signal MIC différentiel et enfin un décodeur local recevant le signal MIC différentiel et servant à former le signal de prédiction, le décodeur local et le décodeur distant étant formés de la même manière et comportant un quantificateur inverse du quantificateur précité et un filtre formé d'une ou plusieurs cellules de filtrage en cascade du deuxième ordre, à deux coefficients et à fonction de transfert réglable, chaque coefficient réglable desdites cellules de filtrage étant calculé par récurrences sucessives, le terme de modification de chaque coefficient réglable étant calculé a chaque récurrence à partir du produit du signal sortant dudit quantificateur inverse et du gradient dudit signal de différence vis à vis dudit coefficient réglable, des moyens étant prévus pour tester si, pour chaque cellule et a chaque récurrence, chaque coefficient réglable affecté d'un terme de modification calculé est plus élevé qu'une valeur limite supérieure ou plus faible qu'une valeur limite inférieure, ces valeurs limites étant déterminées pour que les pôles (ou les racines) de la fonction de transfert en z de ladite cellule soit juste à l'intérieur du cercle de rayon unite.

On sait que la transmission de signaux codés en MIC différentiel permet d'obtenir dans une voie de transmission un débit binaire moindre que si ces signaux étaient codés en MIC.

Par exemple, si un signal MIC normalisé de 8 bits est converti en un signal MIC différentiel de 4 bits échantilloné à la meme fréquence de 8kHz, la transmission en MIC différentiel peut être effectuée avec un débit de 32 kbits/S au lieu du débit de 64 kbit/s nécessaire pour la transmission en MIC. Mais actuellement, les réseaux numériques de communications téléphoniques sont conçus pour la transmission et la commutation de signaux MIC normalisés de 8 bits. Si l'on veut bénéficier dans les réseaux existants de la réduction du débit binaire qu'offre la transmission en MIC différentiel, on doit effectuer â l'entrée de chaque voie de transmission une conversion de signal MIC en signal différentiel et, à la sortie de chaque voie reliée à un centre de commutation, la conversion inverse de signal MIC différentiel en signal MIC. Une liaison téléphonique dans un réseau constitué de cette manière peut nécessiter ainsi une cascade de conversions MIC-MIC différentiel et inversement.

Dans le système de transmission MIC différentiel décrit dans le brevet français N° 2 441 971, on évite l'accumulation du bruit produit à chaque conversion et le désalignement possible des filtres numériques du décodeur local et du décodeur distant, en formant ces filtres par une cascade de cellules de filtrage ayant chacune un dispositif d'arrondi (ou de troncation) avec un pas égal à l'échelon de quantification du signal de différence formé dans le codeur. Cet échelon de quantification est de préférence variable et adapté automatiquement au niveau du signal de différence pour que ce dernier soit codé au mieux avec le nombre de bits réduit du signal MIC différentiel.

Mais, il n'en reste pas moins que dans le système de transmission MIC différentiel envisagé, la conversion du signal MIC entrant en signal MIC différentiel produit un bruit de quantification qu'il est important de réduire le plus possible pour améliorer la qualité de transmission. Comme ce bruit de quantificaiton est proportionnel au signal de différence qui est quantifié dans le codeur, on doit s'attacher à réduire le plus possible ce signal de différence et donc obtenir un signal de prédiction qui soit le plus proche possible du signal MIC entrant dans le codeur. On peut montrer que le filtre de prédiction idéal a une réponse qui est l'image du spectre du signal à transmettre. or les signaux à transmettre peuvent être de nature variée: signaux de parole ou de données et l'on doit de plus distinguer, pour les signaux de parole notamment, entre le spectre à long terme et le spectre à court terme pour des durées syllabiques. Dans le brevet N° 2 441 971 il est préconisé un filtre de prédiction fixe réalise par une cascade de cellules de filtrage d'ordre quelconque, mais n'ayant qu'un seul coefficient et procurant une réponse de compromis entre ces différents spectres. Mais un tel filtre de prédiction fixe n'est que rarement bien adapté à un instant donné au signal et ne permet pas toujours d'obtenir la qualité de transmission requise.

Pour éviter cet inconvénient,il est connu d'utiliser un filtre de prédiction adapatatif. Ainsi le document "IEEE Transactions on Acoustics, Speech, and Signal Processing" Vol ASSP- 29 - N° 3, juin 1981, pages 337 - 341, decrit un système de transmission MIC différentiel avec filtre de prédiction adaptatif. Ce filtre est constitué par une cellule récursive du deuxième ordre de structure classique (fonction de transfert en Z de la forme $g(z) = 1/1 - \alpha z^{-1} - \beta z^{-2}$) avec deux coefficients $\alpha$ et $\beta$ réglables et ajustés pour minimiser la valeur quadratique moyenne du signal de différence engendré dans le codeur. Mais dans ce document, le problème du test des coefficients calculés qui se pose forcément pour vérifier la stabilité du filtre n'est même pas abordé. Or même avec un filtre de prédiction aussi simple et ne per mettant pas de réaliser toutes les fonctions de transfertsouhaitables, le test des deux coefficients est relativement compliqué, car la valeur limite d'un coefficient pour la stabilité depend de l'autre coefficient.

La demande de brevet européen N° 0024243 décrit, pour un système de transmission MIC différentiel, un filtre de prédiction adaptatif d'ordre N formé de N cellules de filtrage en parallèle à un coefficient, d'ordres respectifs 1, 2,...N. Ce filtre peut avoir N coefficients réglables. Mais le test des coefficients pour vérifier la stabilité du filtre n'est décrit que dans le cas où N = 2. Même dans ce cas, ce test est assez compliqué pour la raison évoquee ci-dessus. Pour N > 2, il est facile de voir que la complexité croit très rapidement avec N, puisque la valeur limite d'un coefficient dépend des valeurs des autres coefficients.

2

La demande de brevet français N 2 481 026 décrit aussi un système de transmission MIC différentiel muni d'un filtre de prédiction adaptatif. La structure de ce filtre est classique et le problème du test des coefficients de ce filtre n'est même pas envisagé.

Enfin, le document "IEEE Transactions on Acoustics, Spéech, and Signal Processing", Vol ASSP-26, N 6, décembre 1978 pages 158-528 décrit un prédicteur adaptatif formé de cellules de filtrage en cascade ayant chacune deux coefficients réglables. Mais ce prédicteur ne peut être utilisé dans un système de transmission MIC différentiel avec débit binaire réduit par rapport au débit du signal MIC entrant dans le codeur et il ne s'y pose pas de problème de stabilité. En effet, ce prédicteur de fonction de transfert H utilisé dans un codeur recevant un signal x(n) et ayant la fonction de transfert 1 - H pour fournir un signal de différence e(n), serait a utiliser dans le cas d'une transmission en MIC différentiel, avec un décodeur distant ayant la fonction de transfert

$$\frac{1}{1 - H}$$

et recevant le signal de différence e'(n) $\neq$ e(n) résultant d'un quantificateur Q à la sortie du codeur pour former le signal MIC différentiel à nombre de bits réduit et d'un quantificateur inverse $Q^{-1}$ à l'entrée du décodeur. En appelant x'(n) le signal fourni par le décodeur, on peut montrer que l'on a: $x(n) - x''(x) = [ e(n) - e'(n) ] . \frac{1}{1-H}$

ce qui montre que le bruit [ e(n) - e'(n)] engendré par les deux quantificateurs Q et $Q^{-1}$ se trouverait amplifié par le facteur

$$\frac{1}{1 - H}$$

qui est d'autant plus grand que la prédiction est meilleure (H $\rightarrow$ 1). Au contraire, par le fait que dans le systeme de transmission MIC différentiel concerné par l'invention, le codeur a une structure récursive qui incorpore dans sa boucle un décodeur local identique au décodeur distant et comportant en particulier le quantificateur inverse $Q^{-1}$, il ne se produit aucune amplification du bruit e(n) - e'(n). D'autre part, comme le prédicteur décrit dans le document précité "IEEE...", décembre 1978 est formé d'une cascade de cellules non récursives toujours stables et qu'il est utilisé dans une structure non récursive pour former une erreur de prédiction, le problème du test des coefficients du prédicteur qui se poserait forcément dans un système de transmission, n'a même pas à être envisage.

Le but de la présente invention est donc de résoudre le problème du test de stabilité du filtre de prédiction dans un système de transmission MIC différentiel à prédiction adaptative, ce problème n'étant abordé dans l'art antérieur que pour des filtres de prédiction d'ordre faible. L'invention vise donc à fournir un filtre de prédiction adaptatif, dont le test de stabilité reste simple quel que soit l'ordre du filtre.

Conformément à l'invention, dans un système de transmission MIC différentiel avec filtre de prédiction adaptatif formé d'une ou plusieurs cellules de filtrage en cascade et à fonction de transfert réglable, chaque cellule de filtrage est du type récursif répondant à la fonction de transfert en z, $g'(z) = 1/1 - \beta (\delta z^{-1} + z^{-2})$ ou du type non récursif répondant à la fonction de transfert en z, $h'(z) = 1 + b (d z^{-1} + z^{-2})$, $\beta$ et b étant des coefficients réglables, $\delta$ et d étant des coefficients fixes, le gradient $G_\beta$ (ou $G_b$) étant obtenu en appliquant le signal sortant dudit quantificateur inverse à une cellule de calcul de gradient répondant à la fonction de transfert $g'(z)$ (ou $\frac{1}{h'(z)}$)

avec un coefficient fixe $\delta$ (ou d) approximativement egal a celui de la cellule correspondante des filtres du décodeur local et du décodeur distant, le gradient $G_\beta$ (ou $G_b$) étant prélevé en un endroit de la cellule de calcul de gradient où le signal de sortie de cette cellule est multiplié par la fonction de Z, $\delta Z^{-1} + Z^{-2}$ (ou $dZ^{1} + z^{-2}$).

La réalisation des cellules de calcul du gradient peut être simplifiée et l'alignement des filtres du décodeur local et du décodeur distant peut être facilité dans un mode de réalisation de l'invention selon lequel, dans les cellules de calcul du gradient, le coefficient $\beta$ (ou b) est maintenu à une valeur fixe $\delta$ (ou c).

La description suivante, en regard des dessins annexés, le tout donné à titre d'exemple, fera bien comprendre comment 1,inven-tion peut être réalisée.

La figure 1 représente un mode de réalisation du codeur MIC différentiel du système de l'invention, utilisant des cellules de filtrage récursives à deux coefficients réglables.

La figure 2 représente le décodeur à associer au codeur de la figure 1.

La figure 3 est un diagramme montrant les conditions à respecter pour les deux coefficients de chaque cellule de filtrage.

La figure 4 est un schéma simplifié d'un codeur MICdifférentiel.

La figure 5 représente un schéma montrant les fonctions à remplir dans les circuits de réglage des coefficients des cellules à deux coefficients réglables.

La figure 6 représente un mode de réalisation du codeur MIC différentiel du système de l'invention, utilisant un seul coefficient réglable dans les cellules récursives des filtres du codeur et deux coefficients fixes dans les cellules de calcul de gradient.

La figure 7 représente le décodeur à associer au codeur de la figure 6.

La figure 8 est un organigramme montrant les opérations à effectuer pour la détermination du coefficient d'une cellule de filtrage à un coefficient réglable, par l'intermédiaire d'une variable auxiliaire.

Les figures 9 et 10 représentent ensemble un organigramme montrant les opérations à effectuer pour la détermination du couple de coefficients d'une cellule de filtrage à deux coefficients réglables, par l'intermédiaire de deux variables auxiliaires.

La figure 11 représente un mode de réalisation du codeur MIC différentiel du système de l'invention, utilisant des cellules récursives et non récursives à deux coefficients réglables.

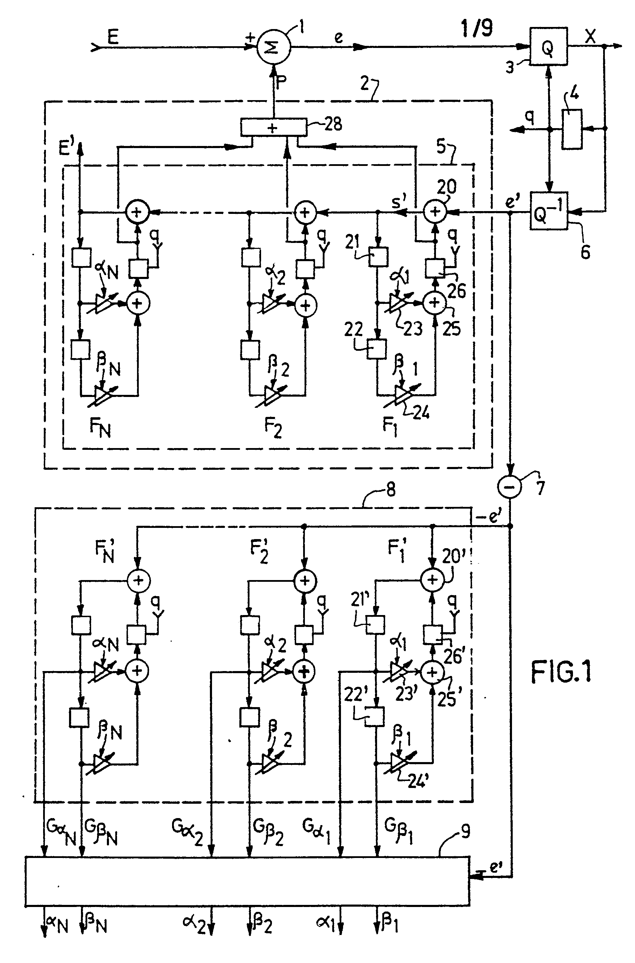

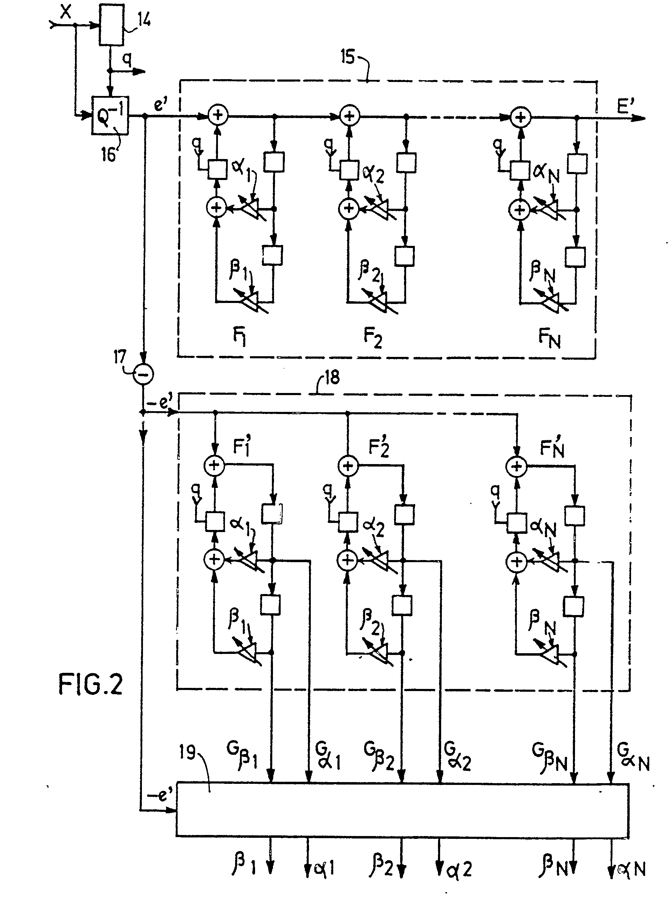

Les figures 1 et 2 représentent respectivement le codeur et le décodeur distant qui lui est associé dans un système de transmission MIC différentiel. Ce codeur et ce décodeur sont du type décrit dans le brevet français n 2 441 971 et sont munis des perfectionnements conformes à la présente invention.

Selon la figure 1, à l'entrée du codeur est appliqué un signal MIC E, formé d'échantillons codés linéairement à 12 bits et résultant par exemple d'une extension sur un signal MIC comprimé à 8 bits, utilisé généralement pour la transmission dans les réseaux de communication numériques. Ces échantillons se produisent à la cadence de 8 kHz. Le circuit soustracteur 1 forme un signal de différence e entre le signal MIC linéaire entrant E et un signal de prédiction P élaboré dans le filtre de prédiction 2 comme on l'expliquera par la suite. Le signal de différence e est quantifié selon une loi linéaire ou non dans le quantificateur 3 par comparaison avec un certain nombre de niveaux déduits d'un échelon de quantification q. Il résulte de cette opération Q de quantification du signal de différence e, le signal X codé en MIC différentiel, qui est à transmettre. Ce signal X est formé par exemple d'échantillons de 4 bits se produisant à la cadence d'échantillonnage 8 kHz du signal MIC E entrant.

Il est avantageux que la grandeur de l'échelon de quantification q soit adaptée au niveau du signal de différence e, pour utiliser au mieux toute la dynamique d'un signal MIC différentiel à 4 bits. Pour cela on utilise un circuit de compression 4 décrit par exemple dans le brevet 2 441 971 et dans lequel, à partir du signal X, est élaboré un échelon de quantification variable q qui est appliqué au quantificateur 3 agencé pour travailler avec un tel échelon variable.

Le signal MIC différentiel X est également appliqué à un quantificateur 6 qui effectue une opération de quantification $Q^{-1}$ inverse de celle opérée dans le quantificateur 3, en utilisant également l'échelon de quantification variable q. Le quantificateur inverse 6 fournit un signal e' dont la valeur est voisine du signal de différence e et qui est appliqué au filtre de prédiction 2.

Selon le brevet français 2 441 971, le filtre de prédiction 2 comporte un filtre 5 formé par un montage en cascade de N cellules de filtrage $F_1$ $F_2$... $F_N$ et recevant le signal e', chaque cellule pouvant être de type récursif ou non récursif. Pour une meilleure compréhension du système, on peut considérer que le quantificateur 6 et le filtre 5 constituent le décodeur local incorporé dans le codeur; à la sortie de ce filtre 5 constituant la sortie du décodeur local apparaît un signal E' qui doit être identique au signal restitué par le décodeur distant. En fait le signal de sortie E' du décodeur local n'est pas utilisé dans le codeur. On y utilise le signal de prédiction P qui est formé à la sortie du circuit additionneur 28, comme la somme de signaux prélevés dans les cellules de filtrage $F_1$ à $F_N$, en des endroits précisés plus loin.

Sur la figure 2, est représenté le décodeur distant associé au codeur représenté sur la figure 1. Ce décodeur reçoit, via le milieu de transmission, le signal MIC différentiel X fourni par le codeur et est chargé de restituer un signal MIC de valeur la plus voisine possible du signal E entrant dans le codeur de la figure 1. Ce décodeur distant a la même structure que le décodeur local incorporé dans le codeur et doit être formé d'éléments identiques. Il comprend le circuit de compression 14 et le quantificateur inverse 16 qui sont identiques aux éléments correspondants 4 et 6 du codeur et qui reçoivent le signal MIC différentiel X. Le circuit de compression 14 fournit l'échelon de quantification variable q au quantificateur inverse 16. Ce dernier fournit le signal e' qui est appliqué au filtre 15 identique au filtre correspondant 5 du décodeur incorporé dans le codeur. Le filtre 15 est donc formé du montage en cascade des mêmes cellules $F_1$, $F_2$... $F_N$ qui constituent le filtre 5. A la sortie du filtre 15 se trouve restitué le signal MIC désiré E', identique au signal que l'on aurait pu obtenir à la sortie du montage en cascade des cellules constituant le filtre 5.

Dans le brevet français n° 2 441 971, on a préconisé, pour résoudre les problèmes d'alignement en fonctionnement des filtres 5 et 15, que les cellules de filtrage $F_1$, $F_2$... $F_N$, de type récursif ou non récursif et d'ordre quelconque, ne comportent qu'un seul coefficient différent de zéro. Or, en pratique, on a constaté que cette restriction concernant le nombre de coefficients de chaque cellule de filtrage n'était pas nécessaire pour obtenir l'alignement des filtres 5 et 15, c'est-à-dire pour que ces filtres recevant le même signal e' restituent dans toutes les circonstances le même signal E', après un temps de convergence raisonnable. Une amélioration apportée par la présente invention consiste donc à prévoir que chaque cellule de filtrage $F_1$, $F_2$ ou $F_N$ est du premier ou du deuxième ordre, les cellules du deuxième ordre pouvant avoir deux coefficients. Avec la possibilité ainsi offerte d'utiliser des cellules du second ordre à deux coefficients, c'est-à-dire les plus générales, le spécialiste comprendra aisément que les filtres 5 et 15 et donc le filtre de prédiction 2 peuvent réaliser une fonction de transfert quelconque, représentable d'une manière générale, en utilisant la transformée en Z, par une fraction dont le numérateur et le dénominateur sont respectivement des polynômes en Z correspondant à la partie non récursive et à la partie récursive de ces filtres. En fait, la partie récursive ou non récursive de ces filtres est réalisée le plus avantageusement par une cascade de filtres du second ordre auxquels est adjoint un filtre du premier ordre quand le degré du polynôme en Z est impair.

4

Sur les figures 1 et 2 les cellules de filtrage $F_1$, $F_2$... $F_N$ sont toutes représentées comme des cellules du second ordre, de type récursif et ayant chacune la fonction de transfert en Z du type:

$$g(Z) = \frac{1}{1 - \alpha Z^{-1} - \beta Z^{-2}} \qquad (1)$$

$Z^{-1}$ e: $Z^{-2}$ correspondant à des retards T et 2T, T étant la période d'échantillonnage, $\alpha$ et $\beta$ étant des coefficients de filtre.

Il est utile de préciser pour la suite, les conditions que doivent remplir les coefficients $\alpha$ et $\beta$ pour que le filtre récursif représenté par la fonction de transfert g(Z), soit stable. On sait que la condition de stabilité d'un filtre récursif est que les pôles de sa fonction de transfert en Z soient à l'intérieur du cercle de rayon unité. On peut montrer qu'il en résulte pour les coefficients $\alpha$ et $\beta$ les conditions:

$$\begin{cases} |\beta| < 1 \\ -1 + \beta < \alpha < 1 - \beta \end{cases} \qquad (2)$$

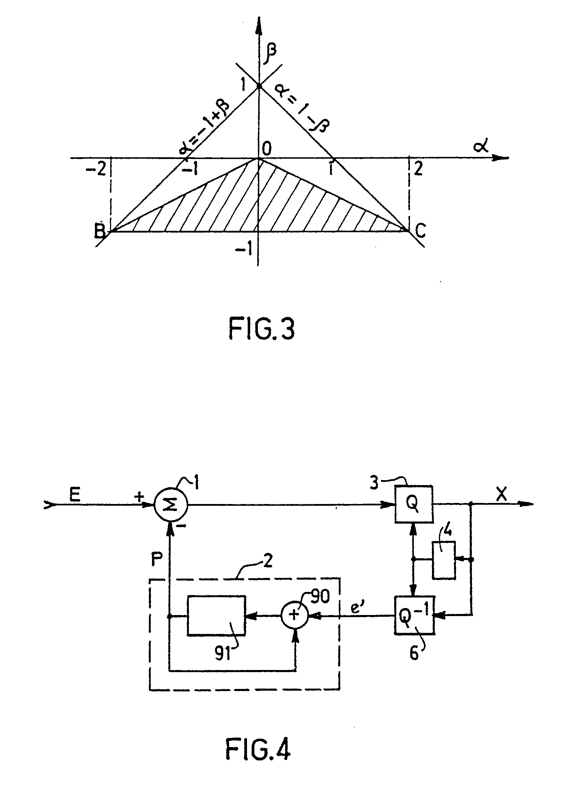

Sur le diagramme de la figure 3 où les coefficients $\alpha$ et $\beta$ sont portés respectivement en abscisses et en ordonnées, les conditions (2) se traduisent par le fait que le point de coordonnées $\alpha$ et $\beta$ doit être à l'intérieur du triangle limité par les droites $\beta = -1$, $\alpha = -1 + \beta$, $\alpha = 1 - \beta$.

La cellule $F_1$ est formée par le circuit additionneur 20 qui reçoit sur une entrée le signal e' entrant dans la cellule et fournit le signal s'sortant de la cellule. Le signal s'est appliqué aux circuits 21 et 22 en cascade, procurant chacun le retard T. Le signal sortant du circuit 21 est multiplié par le coefficient $\alpha_1$ à l'aide du circuit multiplicateur 23 et le signal sortant du circuit 22 est multiplié par le coefficient $\beta_1$, à l'aide du circuit multiplicateur 24. Les deux produits ainsi formés sont additionnés dans le circuit additionneur 25 et la somme ainsi formée est arrondie (ou tronquée) par le quantificateur 26, avec un pas égal à l'échelon de quantification q formé par le circuit de compression 4 dans le codeur ou le circuit de compression 14 dans le décodeur. Le signal ainsi arrondi (ou tronqué) est appliqué à la deuxième entrée du circuit additionneur 20. Les autres cellules de filtrage $F_2$ à $F_N$ en cascade avec la cellule $F_1$ sont constituées de la même manière et utilisent respectivement les paires de coefficients $(\alpha 2, \beta 2)$ à $(\alpha N, \beta N)$.

Avec un filtre 5 formé de cellules de filtrage du second ordre en cascade, on obtient le signal de prédiction P de façon remarquablement simple; ce signal de prédiction P est obtenu en formant, à l'aide du circuit additionneur 28 la somme des signaux prélevés dans les cellules en cascade $F_1$ à $F_N$ entre les quantificateurs tels que 26 et les circuits additionneurs tels que 20.

On va montrer que le signal de prédiction peut effectivement être formé de cette manière, en utilisant le schéma général d'un codeur MIC différentiel montré sur la figure 4. Sur ce schéma, on retrouve les éléments 1, 2, 3, 4 et 6 agencés entre eux comme sur la figure 1. Le filtre de prédiction 2 est un filtre récursif formé d'un circuit additionneur 90 recevant sur ses deux entrées le signal d'entrée e' du filtre et le signal de sortie du dispositif de calcul 91. Ce dernier reçoit le signal de sortie de l'additionneur et fournit le signal de prédiction P. Le dispositif de calcul 91 effectue une sommation de 2N échantillons successifs appliqués à son entrée et pondéres; ce calcul est représentable par la fonction en Z:

$$\sum_{i=1}^{2N} A_i \, Z^{-i}, \quad A_i$$

étant les coefficients de pondération.

La fonction de transfert H(Z) =

$$\frac{X(Z)}{E(Z)}$$

du codeur de la figure 3 peut alors s'écrire:

$$H(Z) = \cfrac{Q}{1 + \cfrac{\displaystyle\sum_{i=1}^{2N} A_i \, Z^{-i}}{1 - \displaystyle\sum_{i=1}^{2N} A_i \, Z^{-i}}}$$

Par ailleurs, on peut écrire:

$$1 - \sum_{i=1}^{2N} A_i \, Z^{-i} = \prod_{i=1}^{N} (1 - \alpha_i \, Z^{-1} - \beta_i \, Z^{-2})$$

$\alpha_i$ et $\beta_i$ étant des couples de coefficients déduits des coefficients $A_i$. On peut vérifier qu'il en résulte l'égalité

$$\prod_{i=1}^{N}(1 - \alpha_1 Z^{-1} - \beta_i Z^{-2}) = 1 - \sum_{j=1}^{N} (\alpha_j Z^{-1} + \beta_j Z^{-2}) \prod_{i=j+1}^{N}(1 - \alpha_i Z^{-1} - \beta_i Z^{-2})$$

Dans ces conditions la fonction de transfert H(Z) peut s'écrire sous la forme:

$$H(Z) = \cfrac{Q}{1 + \displaystyle\sum_{j=1}^{N} \cfrac{\alpha_j \, Z^{-1} + \beta_j \, Z^{-2}}{\displaystyle\prod_{i=1}^{j} (1 - \alpha_i Z^{-1} - \beta_i \, Z^{-2})}}$$

La fonction de transfert $K(Z) = \dfrac{P(Z)}{e'(Z)}$ du filtre de prédiction 2 est donc:

$$K(Z) = \sum_{j=1}^{N} \cfrac{\alpha_j \, Z^{-1} + \beta_j \, Z^{-2}}{\displaystyle\prod_{i=1}^{j} (1 - \alpha_i \, Z^{-1} - \beta_i \, Z^{-2})}$$

On peut voir aisément que cette fonction de transfert K(Z) du filtre de prédiction est exactement réalisée par le schéma du filtre de prédiction 2 représenté sur la figure 1; ce filtre comprend une cascade de cellules récursives du deuxième ordre pour traiter le signal d'entrée e' et un circuit additionneur pour former le signal de prédiction P, comme la somme de signaux prélevés dans les cellules de filtrage, chacun de ces signaux etant celui qui, dans chaque cellule de filtrage, est ajouté au signal d'entrée de la cellule.

Dans le cas où le filtre de prédiction est de type non récursif, on peut montrer que le filtre de prédiction peut être formé de façon analogue à l'aide d'une cascade de cellules non récursives du deuxième ordre, et d'un circuit additionneur formant le signal de prédiction P de la même manière, c'est-à-dire comme la somme de signaux dont chacun est celui qui, dans chaque cellule de filtrage, est ajouté au signal d'entrée de la cellule.

Si le filtre de prédiction comporte une partie récursive et une partie non récursive, le filtre de prédiction est alors formé d'une cascade de cellules récursives et non récursives, pouvant être mises dans l'ordre le plus favorable pour la simplicité de la réalisation; le signal de prédiction est alors formé comme la somme des signaux prélevés comme on l'a défini ci-dessus dans les cellules récursives et non récursives.

On peut passer aisément du schéma des cellules de filtrage récursives du deuxième ordre à deux coefficients à des cellules à un coefficient. Ainsi le schéma d'une cellule du premier ordre s'obtient en supprimant la branche de multiplication par le coefficient $\beta_1$ et le schéma d'une cellule du second ordre à un seul coefficient s,obtient en supprimant la branche de multiplication par le coefficient $\alpha_1$. Tout ce qui est expliqué par la suite pour les cellules à deux coefficients, s'applique bien entendu aux cellules à un coefficient, en tenant compte de la branche supprimée dans la cellule.

La présente invention fournit aussi un filtre de prédiction adaptatif avec des moyens de réglage des coefficents des cellules de filtrage $F_1$ à $F_N$ dans le codeur et dans le décodeur distant, en vue de réduire le signal de différence e formé dans le codeur et donc le bruit de quantification du signal MIC différentiel X.

Le critère utilisé pour le réglage des coefficients est avantageusement la minimisation de la valeur quadratique moyenne du signal de différence e, que l'on peut écrire $M|e|^2$, M étant un opérateur indiquant que l'on prend la valeur moyenne de la quantité qui suit.

Cette quantité $M|e|^2$ peut être minimisée par récurrences successives, en utilisant l'algorithme du gradient pour le réglage des coefficients $\alpha_i$ et $\beta_i$ des cellules de filtrage $F_i$ (i entier allant de 1 à N). Les formules de récurrence traduisant cet algorithme sont de la forme:

$$\alpha_i(n + 1) = \alpha_i(n) - \frac{1}{2K_1}\frac{\partial M|e|^2}{\partial \alpha_i} \qquad (3)$$

$$\beta_i(n + 1) = \beta_i(n) - \frac{1}{2K_2}\frac{\partial M|e|^2}{\partial \beta_i} \qquad (4)$$

Ces formules dans lesquelles $K_1$ et $K_2$ sont des coefficients fixes tels que

$$\frac{1}{2K_1}$$

et

$$\frac{1}{2K_2}$$

sont inférieurs à 1, indiquent les modifications à apporter aux coefficients $\alpha_i(n)$ et $\beta_i(n)$ à la récurrence n, pour obtenir les coefficients $\alpha_i(n + 1)$ et $\beta_i(n + 1)$ à la récurrence n + 1. Ces modifications peuvent avantageusement être calculées et effectuées à chaque instant d'échantillonnage du signal de différence e.

En développant les termes de modification des coefficients dans les formules (3) et (4), ces dernières peuvent s'écrire:

$$\alpha_i(n + 1) = \alpha_i(n) - \frac{1}{K_1} M \left[ e \cdot \frac{\partial e}{\partial \alpha_i} \right]$$

$$\beta_i(n + 1) = \beta_i(n) - \frac{1}{K_2} M \left[ e \cdot \frac{\partial e}{\partial \beta_i} \right]$$

Si les coefficients $K_1$ et $K_2$ sont grands par rapport à un, les modifications apportées aux coefficients à chaque récurrence sont très faibles et il est alors pratiquement inutile d'effectuer le calcul de valeur moyenne indiqué par l'opérateur M. On pose d'autre part pour les gradients du signal de différence vis à vis des coefficients $\alpha_i$ et $\beta_i$:

$$\frac{\partial e}{\partial \alpha_i} = G_{\alpha i}$$

$$\frac{\partial e}{\partial \beta_i} = G_{\beta i}$$

Les formules de récurrence à mettre pratiquement en oeuvre pour le réglage de ces coefficients peuvent finalement s'écrire:

$$\alpha_i(n + 1) = \alpha_i(n)$$

$$\alpha_i(n + 1) = \alpha_i(n) - \frac{1}{K_1} \cdot e \cdot G_{\alpha i} \tag{5}$$

$$\beta_i(n + 1) = \beta_i(n) - \frac{1}{K_2} \cdot e \cdot G_{\beta i} \tag{6}$$

On va maintenant montrer comment on peut exprimer les gradients $G_{\alpha i}$ et $G_{\beta i}$ sous une forme facile à mettre en oeuvre. En utilisant la formule (1) donnant la fonction de transfert d'une cellule récursive, on peut établir aisément qu'entre le signal d'entrée e' et le signal de sortie E' d'un filtre 5 ou 15, on a la relation:
$$e' = E'(1 -\alpha_1 Z^1 -\beta_1 Z^{-2})(1 -\alpha_2 {}^{z-1} -\beta_2 Z^{-2})...(1 -\alpha_N Z^{-1}-\beta_N Z^{-2}) \tag{7}$$
Comme on l'a déjà remarqué, e' est très voisin du signal de différence e. Si l'on assimile e à e', on peut vérifier que l'on a E = E'. Dans ces conditions, d'après la formule précédente, le signal de différence e peut s'écrire:
$$e = E(1-\alpha_1 Z^{-1} -> 82_1 Z^{-2})(1 -\alpha_2 Z^{-1} -\alpha_2 Z^{-2})...(1 -\alpha_N Z^{-1}-\beta_N Z^{-2}) \tag{8}$$
On peut déduire de la formule (8) que les gradients $G_{\alpha i}$ et $G_{\beta i}$ peuvent s'écrire respectivement:

$$G_{\alpha 1} = \frac{\partial e}{\partial \alpha_1} = \frac{- e\, Z^{-1}}{1 - \alpha_1 Z^{-1} - \beta_1 Z^{-2}}$$

$$G_{\alpha 2} = \frac{\partial e}{\partial \alpha_2} = \frac{- e\, Z^{-1}}{1 - \alpha_2 Z^{-1} - \beta_2 Z^{-2}} \qquad (9)$$

$$G_{\alpha N} = \frac{\partial e}{\partial \alpha_N} = \frac{- e\, Z^{-1}}{1 - \alpha_N Z^{-1} - \beta_N Z^{-2}}$$

$$G_{\beta 1} = \frac{\partial e}{\partial \beta_1} = \frac{- e\, Z^{-2}}{1 - \alpha_1 Z^{-1} - \beta_1 Z^{-2}}$$

$$G_{\beta 2} = \frac{\partial e}{\partial \beta_2} = \frac{- e\, Z^{-2}}{1 - \alpha_2 Z^{-1} - \beta_2 Z^{-2}} \qquad (10)$$

$$G_{\beta N} = \frac{\partial e}{\partial \beta_N} = \frac{- e\, Z^{-2}}{1 - \alpha_N Z^{-1} - \beta_N Z^{-2}}$$

Les formules (9) montrent que les gradients $G_{\alpha 1}$, $G_{\alpha 2}$... $G_{\alpha N}$ peuvent être obtenus en appliquant le signal e à des cellulesrécursives identiques aux cellules $F_1$, $F_2$... $F_N$ et en retardant de T le signal de sortie de ces cellules. Les formules (10) montrent que les gradients $G_{\beta 1}$, $G_{\beta 2}$,... $G_{\beta N}$ peuvent être obtenus en retardant de 2T le signal de sortie des mêmes cellules.

Dans la pratique, les formules de calcul de gradient (9) et (10) et les formules de récurrence (5) et (6) sont mises en oeuvre, en utilisant au lieu du signal de différence e qui n'est disponible que dans le codeur, le signal e qui est disponible à la fois dans le codeur et le décodeur distant, à la sortie respectivement des quantificateurs inverses 6 et 16.

La mise en oeuvre de ces formules est effectuée dans le codeur comme le montre la figure 1. Le signal e' disponible à la sortie du quantificateur 6 est changé de signe dans le circuit 7 et le signal - e' est appliqué au circuit 8 dans lequel sont calculés les gradients $G_{\alpha i}$ et $G_{\beta i}$. Conformément à la remarque faite ci-dessus, ces gradients sont calculés en appliquant le signal - e' à des cellules de filtrage $F'_1$, $F'_2$... $F'_N$ identiques aux cellules $F_1$, $F_2$... $F_N$ et donc également récursives. Ainsi la cellule $F'_1$ est composée des éléments 20, à 26' identiques aux éléments 20 à 26 de la cellule $F_1$. On peut remarquer notamment dans la cellule $F'_1$, la présence du quantificateur 26' pour arrondir (ou tronquer) le signal dans la cellule avec le pas variable q. Le gradient $G_{\alpha 1}$ est obtenu à la sortie du circuit 21'retardant de T le signal de sortie de la cellule $F'_1$. Le gradient $G_{\beta 1}$ est obtenu à la sortie du circuit 22' produisant un retard T supplémentaire. Les autres gradients sont obtenus de la même manière dans les cellules $F'_2$... $F'_N$. Le signal - e' et les gradients $G_{\alpha i}$ et $G_{\beta i}$ ainsi calculés sont appliqués au circuit 9 dans lequel sont élaborés les coefficients variables $\alpha_i$ et $\beta_i$ conformément aux formules de récurrence (5) et (6)et en respectant les conditions (2) relatives à la stabilité des cellules de filtrage. Les coefficients $\alpha_i$ et $\beta_i$ sont utilisés dans les cellules $F_i$ et $F'_i$ dans lesquelles ils sont appliqués à des multiplicateurs variables tels que 23, 23' et 24 24'.

Dans le décodeur distant les formules de récurrence (5), (6) et les formules de calcul de gradient (9) (10) sont mises en oeuvre de la même manière que dans le codeur, à partir du signal e' apparaissant à la sortie du quantificateur 16. On y trouve les circuits 17, 18 et 19 identiques aux circuits 7, 8 et9du codeur et connectes de la même manière pour fournir les mêmes coefficients $\alpha_i$ et $\beta_i$.

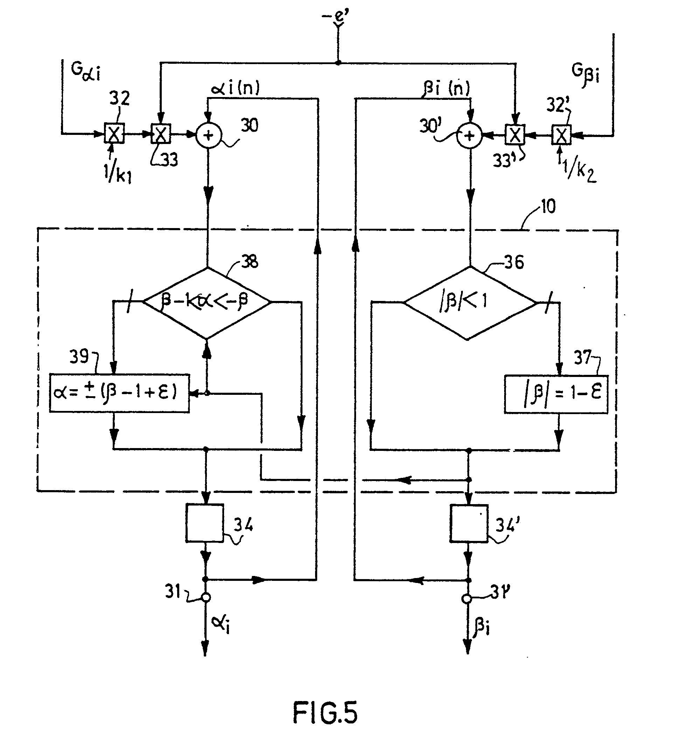

La figure 5 montre la structure du circuit 9 (ou 19), d'élaboration des coefficients $\alpha_i$ et $\beta_i$, à partir des gradients$G_{\alpha i}$ et $G_{\beta i}$ et du signal - e'. Pour élaborer les coefficients $\alpha_i$ conformément à la formule (5), ce circuit 9 comporte un circuit additionneur 30 recevant à un instant d'échantillonnage nT, d'une part un coefficient $\alpha_i(n)$ apparaissant à la sortie 31 du circuit 9 et d'autre part le terme de modification de ce coefficient Ce terme de modification est formé à partir de la valeur à l'instant nT du gradient $G_{\alpha i}$ qui est multiplié par le terme

constant

$$\frac{1}{K_1}$$

dans le circuit multiplicateur 32. Le produit ainsi formé est multiplié par la valeur à l'instant nT du signal - e' a l'aide du circuit multiplicateur 33. La sortie de ce dernier est connectée au circuit additionneur 30. La sortie de ce circuit additionneur forme une nouvelle valeur calculée du coefficient qui est appliquée au circuit 10 pour la vérification des conditions (2) de stabilité. Une sortie de ce dispositif 10 fournit une valeur définitive du coefficient $\alpha_i$ qui, retardée du temps T par le circuit de retard 34, sera utilisée à l'instant d'échantillonnage suivant $(n + 1)T$. Pour élaborer les coefficients $\beta_i$ conformément à la formule (6), le dispositif 9 utilise les gradients $G_{\beta_i}$ et comporte des éléments 30' à 34' ayant la même fonction que les éléments 30 à 34 décrits ci-dessus, le circuit multiplicateur 32' effectuant toutefois une multiplication par le terme constant

$$\frac{1}{K_2}.$$

Une nouvelle valeur calculée d'un coefficient $\beta_i$ apparaît à la sortie du circuit additionneur 30' et est appliquee au circuit 10 pour vérification des conditions (2) de stabilité. Une deuxième sortie de ce circuit 10 fournit une valeur définitive du coefficient $\beta_i$ à utiliser à l'instant $(n + 1)T$ après retard dans le circuit 34,.

L'obtention dans le circuit 10 de coefficients $81_i$ et $\beta_i$ répondant aux conditions (2) de stabilité des cellules de filtrage est effectuée conformément à l'organigramme indiqué à l'intérieur du circuit 10 et que l'homme de l'art peut aisément mettre en oeuvre. Les valeurs calculées $\beta$ des coefficients $\beta_i$ apparaissant à la sortie du circuit additionneur 30' sont appliquées à un organe de comparaison 36 qui vérifie si $|\beta| < 1$. Si cette condition est vérifiée, la valeur $\beta$ peut être utilisée comme valeur définitive du coefficient $\beta_i$. Si cette condition n'est pas vérifiée, la valeur définitive retenue pour le coefficient $\beta_i$ est telle que $|\beta| = 1 - \varepsilon$ (Case 37), $\varepsilon$ étant faible par rapport à 1. Les valeurs $\alpha$ des coefficients $\alpha_i$ apparaissant à la sortie du circuit additionneur 30 sont appliquées à un organe de comparaison 38 qui vérifie si $\beta - 1 < \alpha < - \beta + 1$, les valeurs de $\beta$ à utiliser étantles valeurs définitives fournies par l'autre branche du circuit 10. Si cette condition est vérifiée, la valeur $\alpha$ peut être utilisée comme valeurdéfinitive du coefficient $\alpha_i$. Si cette condition n'est pas vérifiée, la valeur définitive retenue pour le coefficient $\alpha_i$ est la valeur limite $\alpha = \beta - 1 + \varepsilon$ ou $- \beta + 1 - \varepsilon$ (Case 39), selon que $\alpha$ est négatif ou positif.

Il est clair pour le spécialiste qu'un seul dispositif tel que celui de la figure 5, peut être utilisé pour modifier tous les coefficients $\alpha_i$ et $\beta_i$, en faisant travailler ce dispositif au cours d'une période T, successivement sur tous les couples de coefficients $(\alpha_i, \beta_i)$.

Enfin comme cela est bien connu dans ce genre de dispositif mettant en oeuvre des formules de récurrence pour modifier des coefficients, on peut éviter d'avoir à effectuer réellement les opérations assez compliquées, requises pour calculer les termes de modification des coefficients intervenant dans les formules (5) et (6). Au lieu d'utiliser la grandeur et le signe des gradients $G_{\alpha_i}$ et $G_{\beta_i}$ et du signal - e', on peut utiliser seulement le signe pour déterminer s'il y a lieu d'effectuer une augmentation ou une diminution du coefficient $\alpha_i$ ou $\beta_i$. Si le gradient a le même signe que le signal - e', on doit effectuer une augmentation du coefficient et si le gradient a un signe différent du signal - e', on doit effectuer une diminution du coefficient. La complexité des circuits de calcul dans le dispositif 9 peut être ainsi réduite de façon importante, au prix toutefois d'une augmentation du temps de convergence des coefficients vers leurs valeurs idéales, car les augmentations et diminutions des coefficients ont toujours la même valeur qui doit être très faible.

Les opérations de vérification des coefficients dans le dispositif 10 pour obtenir les coefficients des cellules de filtrage restent encore relativement compliquées. Pour simplifier ces opérations, il est avantageux selon une variante de l'invention, d'utiliser des cellules de filtrage $F_1$ à $F_N$ ayant une structure différente. Cette nouvelle structure est basée sur un changement de variable sur les coefficients, dans la fonction de transfert en Z de la cellule, par exemple dans la fonction de transfert $g(Z)$ d'une cellule récursive du second ordre, définie à la formule (1). On peut écrire:

$$g(Z) = \frac{1}{1 - \alpha Z^{-1} - \beta Z^{-2}} = \frac{1}{1 - \beta(\frac{\alpha}{\beta} Z^{-1} + Z^{-2})}$$

En posant: $\delta = \alpha\_\beta$

la fonction g(Z) s'écrit:

$$g'(Z) = \frac{1}{1 - \beta(\delta Z^{-1} + Z^{-2})} \qquad (11)$$

Avec ce changement de variable, les deux coefficients de la cellule récursive définie par g"(Z) deviennent $\beta$ et $\delta$.

Les conditions à vérifier sur ces coefficients, pour la stabilité de la cellule, deviennent:

$$\begin{cases} |\beta| < 1 \\[2mm] |\delta| < \dfrac{|1 - \beta|}{|\beta|} \end{cases} \qquad (12)$$

On peut simplifier la vérification des conditions de la stabilité, en se limitant aux valeurs de $\beta$ négatives Les conditions (12) deviennent alors:

$$\begin{cases} -1 < \beta \leqslant 0 \\ -2 \leqslant \delta \leqslant 2 \end{cases} \qquad (13)$$

Avec les conditions (13), les deux coefficients $\alpha$ et $\beta$ peuvent être vérifiés indépendamment l'un de l'autre ce qui constitue une simplification considérable de cette vérification. Reportées sur le diagramme de la figure 3, les conditions (13) signifient que le point de coordonnées $\alpha$ et $\beta$ doit se trouver à l'intérieur du triangle hachuré 08C.

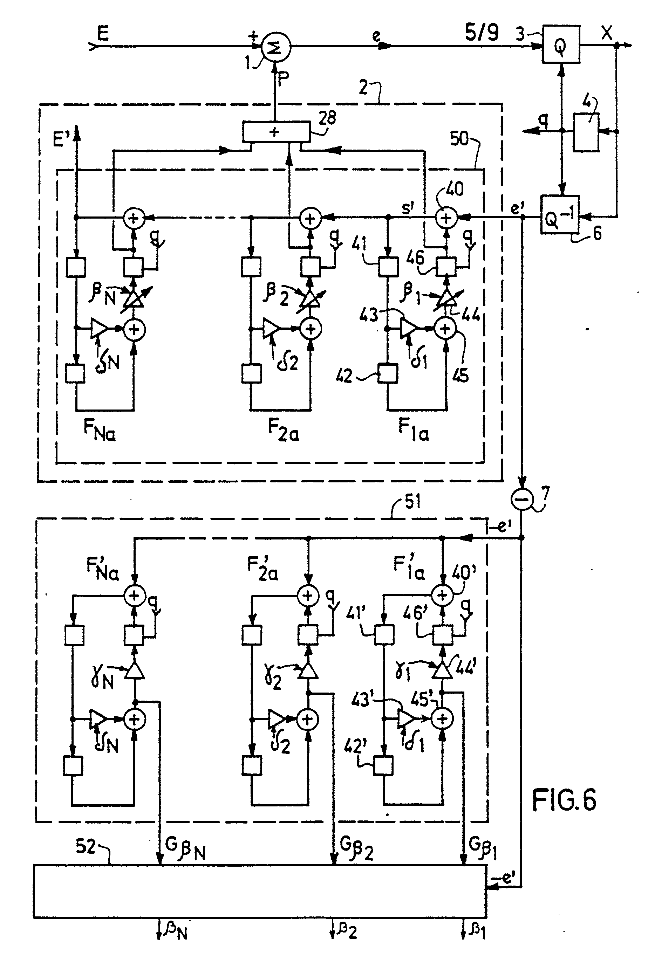

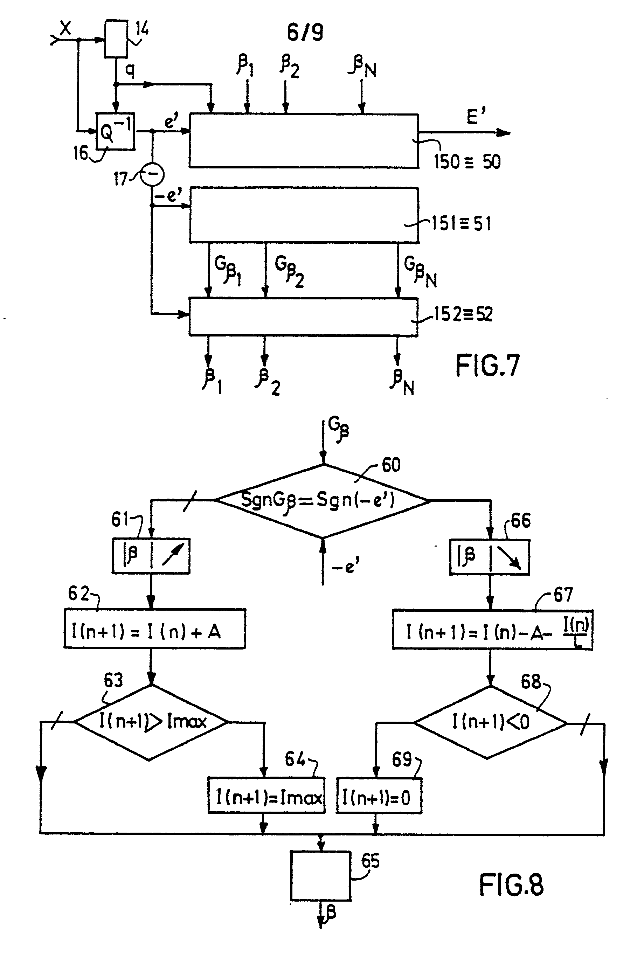

Les figures 6 et 7 représentent respectivement le codeur et le décodeur distant, utilisant des cellules de filtrage récursives du type représenté par la fonction de transfert g"(Z) de la formule (11). Sur ces figures, un certain nombre d'éléments identiques à ceux des figures 1 et 2 portent les mêmes références.

Selon la figure 6, le filtre de prédiction 2 du codeur comporte un ensemble de filtrage 50 formé par le montage en cascade de cellules récursives $F_{1a}$, $F_{2a}$... $F_{Na}$, ayant chacune la fonction de transfert de la formule (11). La cellule de filtrage $F_{1a}$ est formée par le circuit additionneur 40 qui reçoit le signal d'entrée e' et fournit le signal s'. Ce dernier est appliqué aux deux circuits de retard T, 41 et 42 montés en cascade. Le signal sortant du circuit 41 est multiplié par le coefficient $\delta_1$ dans le circuit multiplicateur 43 et le produit ainsi formé est ajouté au signal sortant du circuit 42 à l'aide du circuit additionneur 45. La somme ainsi formée est multipliée par le coefficient $\beta_1$ à l'aide du circuit multiplicateur 44. Le signal fourni par le circuit 44 est appliqué au circuit additionneur 40 par l'intermédiaire du quantificateur 46, qui arrondit ou tronque le signal qui lui est appliqué avec un pas égal à l'échelon de quantification q fourni par le circuit de compression 4. Les autres cellules $F_{2a}$ à $F_{2N}$ sont constituées de la même manière et utilisent les coefficients $(\beta_2, \delta_2)$... $(\beta_N, \delta_N)$. Le signal de prédiction P est obtenu de façon analogue au codeur de la figure 1, en formant à l'aide du circuit additionneur 28, la somme des signaux obtenus à la sortie des quantificateurs tels que 46. Il s'est avéré dans la pratique, qu'avec des cellules ayant cette structure, on peut obtenir une adaptation suffisante du signal de prédiction P au signal MIC entrant E pour réduire le signal de différence e, en utilisant dans les cellules de filtrage $F_{1a}$ à $F_{Na}$ un seul jeu de coefficients variables, les coefficients $\beta_1$ à $\beta_N$, tandis que le jeu des coefficients $\delta_1$ à $\delta_N$ peut être fixe, avec des valeurs judicieusement réparties. On peut alors réaliser de façon beaucoup plus simple les calculs dans les cellules de filtrage. Seuls les multiplicateurs par les coefficients $\beta_1$ à $\beta_N$ effectuent des multiplications compliquées par des coefficients variables. Si les coefficients fixes $\delta_1$ à $\delta_N$ sont choisis comme des puissances de deux, les multiplications correspondantes consistent en de simples décalages et sont pratiquement gratuites. En outre, d'après les conditions (13), si l'on choisit des valeurs $\delta$ des coefficients $\delta_i$ telles que $-2 \leqslant \delta \leqslant +2$, la stabilité des cellules est obtenue, en vérifiant simplement que les valeurs $\beta$ des coefficients variables $\beta_i$ sont telles que $-1 < \beta$

⩽ 0. Oans un mode de réalisation pratique de l'ensemble de filtrage 50, on a utilisé 5 cellules de filtrage ayant leurs coefficients $\beta_1$ à $\beta_5$ variables et leurs coefficients $\delta_1$ à $\delta_5$ de valeurs respectivements égales a - 2, - 1, 0, 1 et 2

Les coefficients variables $\beta_i$ des cellules que l'on vient de décrire peuvent être réglés par récurrences successives suivant une formule de récurrence analogue à la formule (6), soit:

$$\beta_i(n + 1) = \beta_i(n) - \frac{1}{k} \cdot e \cdot G_{\beta i} \qquad (14)$$

Dans cette formule (14) k est un coefficient grand par rapport à 1 et $G_{\beta i}$ est le gradient du signal de différence e par rapport à un coefficient $\beta_i$. On peut montrer par des calculs utilisant la fonction de transfert g'(Z) de la formule (11) que ce gradient peut s'écrire:

$$G_{\beta i} = \frac{\partial e}{\partial \beta_i} = - e \frac{\delta_i Z^{-1} + Z^{-2}}{1 - \beta_i(\delta_i Z^{-1} + Z^{-2})} \qquad (15)$$

Cette formule (15) montre que les gradients $G_{\beta i}$ nécessaires pour mettre en oeuvre la formule de récurrence (14) peuvent être obtenus en appliquant le signal - e à des cellules de calcul de gradient identiques aux cellules $F_{ia}$ du filtre de prédiction et en prélevant le signal à un endroit de ces cellules de calcul de gradient où le signal sortant est multiplié par $(\delta_i Z-1 + Z-2)$. Oans la pratique, on peut utiliser dans les cellules de calcul de gradient et dans les cellules du filtre de prédiction des coefficients fixes $\delta_i$ ayant des valeurs un peu différentes, sans nuire sensiblement à l'adaptation du filtre de prédiction.

On peut aussi, pour des raisons expliquées par la suite, utiliser pour les calculs des gradients, des cellules ayant la même structure que les cellules $F_{ia}$ du filtre de prédiction, mais dans lesquelles les coefficients $\beta_i$ variables sont remplacés par des coefficients $\gamma_i$ fixes. La fonction de transfert de ces cellules de calcul de gradient s'écrit alors:

$$g''(Z) = \frac{1}{1 - \gamma_i(\delta_i Z^{-1} + Z^{-2})} \qquad (16)$$

Ces cellules fournissent une valeur approchée des gradients $G_{\beta i}$, selon l'expression:

$$G_{\beta i} = - e \frac{\delta_i Z^{-1} + Z^{-2}}{1 - \gamma_i(\delta_i Z^{-1} + Z^{-2})} \qquad (17)$$

La figure 6 montre comment les formules (15) ou (17) et la formule de récurrence (14) sont mises en oeuvre dans le codeur. Le signal e' utilisé à la place du signal e est changé de signe dans le circuit 7 et le signal - e' est appliqué au circuit 51 dans lequel sont calculés les gradients $G_{\beta i}$. Le signal - e' est appliqué aux cellulesde filtrage $F'_{1a}$ à $F'_{Na}$ ayant la même structure que les cellules $F_{1a}$ à $F_{Na}$. La cellule $F'_{1a}$ par exemple est composée des éléments 40' à 46' identiques aux éléments 40 à 46 de la cellule $F_{1a}$; le gradient $G_{\beta 1}y$ est prélevé conformément aux formules (15) ou (17) à la sortie du circuit additionneur 45'. Le circuit multiplicateur 43' effectue une multiplication par le même coefficient $\delta_1$ fixe que celui utilisé par le circuit multiplicateur 43. Par contre, en supposant que l'on utilise la formule (17) de calcul des gradients approchés, le circuit multiplicateur 44' effectue une multiplication par un coefficient $\gamma_1$ fixe, au lieu du coefficient $\beta_1$ variable utilisé dans la cellule $F_{1a}$. Les autres cellules de filtrage $F'_{2a}$ à $F'_{Na}$ sont constituées de la même manière que la cellule $F'_{1a}$ et forment de la même façon, en utilisant les coefficients $\delta_2$ à $\delta_N$ et $\gamma_2$ à $\gamma_N$, les gradients $G_{\beta 2}$ à $G_{\beta N}$

Le signal - e' et les gradients $G_{\beta i}$ ainsi calculés sont appliqués au dispositif 52 dans lequel sont élaborés les coefficients $\beta_i$ conformément à la formule de récurrence (14), en respectant la condition de stabilité des cellules de filtrage. La mise en oeuvre de cette formule de récurrence (14) peut être effectuée conformément à la partie droite du schéma de la figure 5, relative aux calculs des coefficients $\beta_i$. Comme on l'a déjà expliqué, ces calculs

peuvent être très simplifiés, si l'on utilise seulement le signe des gradients et du signal (- e'). Conformément aux conditions (13) de stabilité des cellules, les valeurs calculées des coefficients $\beta_i$ sont utilisées directement a la sortie du dispositif 53 si leur valeur $\beta$ est telle que - 1 < $\beta$ ⩽ 0; si cette condition n'est pas vérifiée on donne aux coefficients $\beta_i$ la valeur 0 ou - 1 + $\varepsilon$.

La figure 7 montre le schéma du décodeur distant associé au codeur de la figure 6. Il comporte le filtre 150. identique au filtre 50 du codeur et fournissant le signal E', le circuit 151 identique au circuit 51 du codeur et fournissant les gradients $G_{\beta i}$ et enfin le dispositif 152, identique au dispositif 52 du codeur et fournissant les coefficients variables $\beta_i$, qui sont utilisés dans le filtre 150.

L'utilisation dans les cellules $F'_{ia}$ de calcul des gradients de coefficients fixes $\gamma_i$ au lieu des coefficients variables $\beta_i$, ne fournit qu'une valeur approchée des gradients $G_{\beta i}$; toutefois, avec cette approximation on obtient dans la pratique des coefficients $\beta_i$ très proches de leurs valeurs idéales et conduisant finalement a une adaptation tout à fait satisfaisante du signal de prédiction P au signal MIC entrant E. Mais, outre un avantage évident de simplicité de réalisation, cette manière de faire présente l'avantage de diminuer notablement le temps d'alignement du filtre 50 du codeur (ou du filtre de prédiction 2) et du filtre 150 du décodeur, à la suite d'un désalignement provoqué par la mise en route de la liaison ou par un défaut en ligne. En effet, les filtres 50 et 150 du codeur et du décodeur ne peuvent s'aligner qu'une fois que leurs coefficients variables $\beta_i$ sont identiques. ce qui ne peut se produire que si les cellules de calcul des gradients du codeur et du décodeur sont alignées; or cet alignement des cellules de calcul des gradients peut être très long à obtenir si 1,on y utilise des coefficients $\beta_i$ variables. Par contre si l'on utilise des coefficients $\gamma_i$ fixes, les filtres 50 et 150 peuvent pratiquement être alignés, après seulement leur propre temps d'alignement.

Dans le codeur et le décodeur conformes aux figures 6 et 7, et utilisant dans les cellules $F_{ia}$ et $F'_{ia}$ des coefficients fixes $\gamma_i$ et $\delta_i$, les multiplications par ces coefficients peuvent être presque gratuites si l'on utilise pour ces coefficients des valeurs simples telles que des puissances de deux. Mais il reste à effectuer dans les cellules $F_{ia}$, les multiplications par les coefficients variables $\beta_i$, qui peuvent être compliquées. Pour simplifier dans ces cellules $F_{ia}$ les multiplications par les coefficients $\beta_i$, il est évidemment avantageux que ces derniers aient un nombre de bits réduit. Mais par ailleurs les calculs à effectuer dans les circuits 52 et 152 pour obtenir les coefficients variables $\beta_i$ doivent être effectués avec précision. Il es avantageux alors d'effectuer ces calculs sur une variable auxiliaire appelée index et définie avec un nombre de bits plus grand que les coefficients $\beta_i$. Ces coefficients peuvent être lus sur une table, en fonction de la valeur 1 de l'index. Ce procédé permet également d'attribuer facilement aux coefficients une valeur $\beta$ répondant aux conditions de stabilité des cellules (- 1 < $\beta$ < 0) Il peut permettre de plus d'établir aisément entre la valeur $\beta$ des coefficients et la valeur 1 de l'index, une loi non linéaire, qui peut être avantageuse.

Par ailleurs, il peut être avantageux pour des problèmes d'alignement des filtres 50 et 150 du codeur et du décodeur de faire dépendre les termes de modification des coefficients, non seulement des gradients $G_{\beta i}$. comme l'indique la formule générale de récurrence (14), mais des coefficients eux-mêmes. Ceci est particulièrement utile lorsque l'on utilise pour la modification des coefficients seulement le signe des gradients $G_{\beta i}$ et le signe du signal - e'. Si l'on opère de la sorte. en modifiant les coefficients $\beta_i$ du codeur et du décodeur de la même valeur quelle que soit la valeur de ces coefficients, on risque qu'une différence initiale entre les coefficients correspondants du codeur et du décodeur soit conservée indéfiniment.

On peut éviter cet inconvénient, en faisant dépendre de façon adéquate les termes de modification des coefficients, de la valeur des coefficients eux-mêmes. Dans la technique utilisant l'index et la lecture des coefficients sur une table, on peut par exemple calculer l'index I par l'une ou l'autre des formules de récurrence suivantes:

$$I(n + 1) = I(n) + A \qquad (18)$$

$$I(n + 1) = I(n) - A - \frac{I(n)}{L} \qquad (19)$$

Selon qu'un coefficient $\beta_i$, compris entre 0 et - 1, doit être augmenté ou diminué en valeur absolue en fonction des signes relatifs des gradients $G_{\beta i}$ et du signal - e', on utilise la formule de récurrence (18) ou (19). A et L sont des termes constants qui déterminent les modifications de l'index. Les valeurs de cet index sont en outre limitées aux valeurs $I_{min}$ et $I_{max}$. Dans une mise en oeuvre pratique de ces formules de récurrence on a utilisé par exemple les valeurs: A = 512, L = 128, $I_{min}$ = 0, $I_{max}$ = 65536.

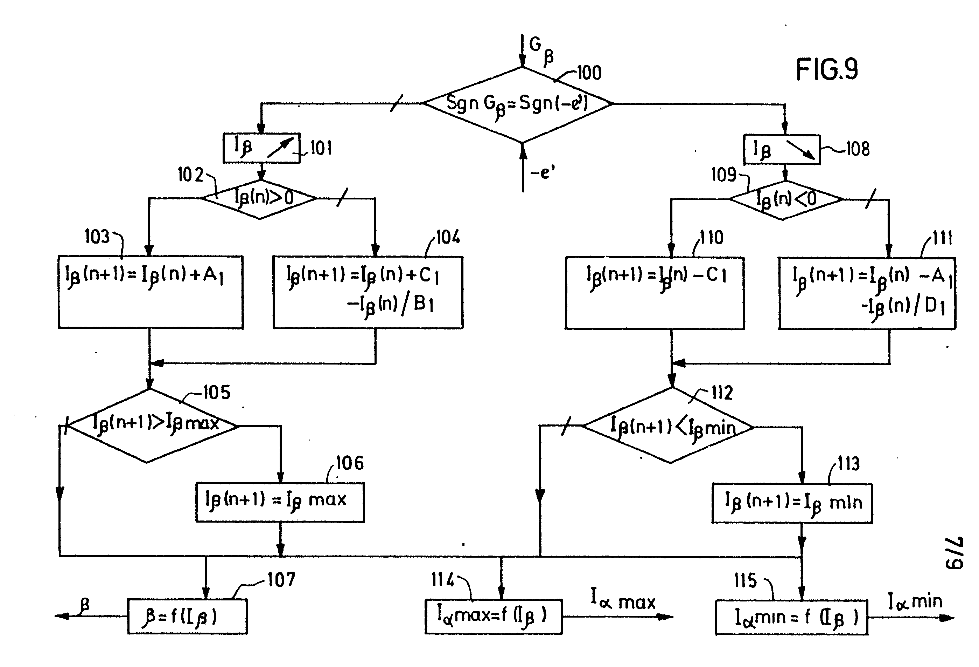

L'organigramme représenté à la figure 8 montre la succession des opérations à effectuer dans les dispositifs de calcul des coefficients 52 et 152, pour obtenir un coefficient $\beta$ parmi les N coefficients $\beta_i$, lorsque sont utilisées les formules de récurrence (18) et (19). Pour déterminer un nouveau coefficient $\beta(n + 1)$, on effectue d'abord (case 60) une comparaison des signes du gradient $G_\beta$ et du signal - e' correspondant à l'instant nT. Des signes différents (branche gauche) indiquent que la valeur absolue du coefficient $\beta$ doit augmenter (case 61) et que l'index I doit augmenter selon la formule (18) (case 62). On teste ensuite (case 63) la nouvelle valeur de l'index I(n + 1) pour vérifier si elle dépasse la valeur limite $I_{max}$. Si cette condition est vérifiée. la nouvelle valeur de l'index retenue est $I_{max}$ (case 64); elle sert à lire dans une table 65, la valeur limite - 1 + $\varepsilon$ du nouveau

13

coefficient $\beta(n + 1)$. Si la condition $1_{(n + 1)} > I_{max}$ n'est pas vérifiée, la nouvelle valeur de l'index $I(n + 1)$ est retenue et sert à lire directement dans la table 65 la nouvelle valeur de coefficient $\beta(n + 1)$, valeur négative et au maximum égale à $- 1 + \varepsilon$. Si les signes de $G_\beta$ et $- e'$ sont les mêmes, on procède comme l'indique la branche à droite de la case 60. La valeur absolue du coefficient $\beta$ doit décroître (case 66); l'index doit augmenter selon la formule (19) (case 67). On teste ensuite si la valeur du nouvel index $I(n + 1)$ est négative (case 68). Si la valeur $I(n + 1)$ est négative, la nouvelle valeur d'index retenue est $I_{min} = 0$ (case 69), valeur à laquelle la table 65 fait correspondre un coefficient de valeur zéro. Si la valeur $I(n + 1)$ n'est pas négative, elle sert à lire directement dans la table 65 une nouvelle valeur du coefficient.

On peut remarquer que la formule de récurrence (19) utilisée pour diminuer la valeur absolue des coefficients fait dépendre la valeur du nouveau coefficient de sa valeur antérieure. On peut en même temps établir une correspondance non linéaire entre les valeurs de l'index et les valeurs des coefficients lus sur la table 65. Il est judicieux par exemple que des variations égales d'index procurent des variations plus importantes de coefficients lorsque ces coefficients sont proches de zéro et des variations moins importantes lorsque les coefficients sont proches de $- 1$.

Cette technique dans laquelle on utilise une variable auxiliaire (index) pour effectuer les calculs, peut s'appliquer de façon analogue,au cas général représenté par les figures 1 et 2, où les cellules de filtrage F, du codeur et du décodeur ont deux coefficients $\alpha_i$ et $\beta_i$ réglables. Pour obtenir des cellules de filtrage stables, ces coefficients doivent répondre aux conditions (2) ci-dessus.

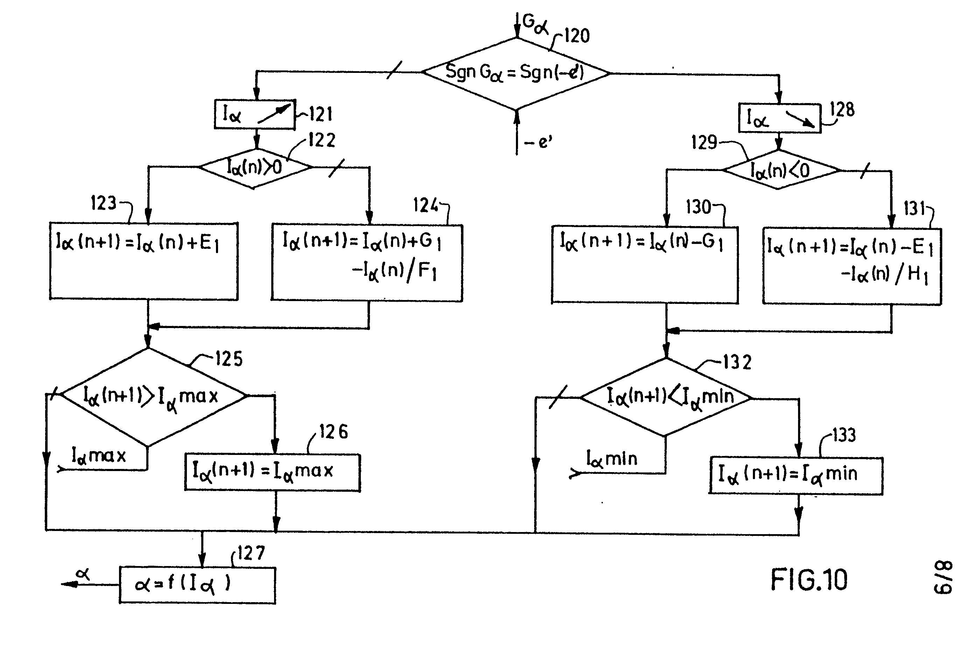

Pour calculer les index $I_\alpha$ et $I_\beta$ relatifs aux coefficients $\alpha_i$ ou $\beta_i$, on peut utiliser des formules de récurrences analogues aux formules (18) et (19), la formule sélectionnée dépendant du signe relatif du signal $- e'$ et des gradients $G_{\alpha i}$ ou $G_{\beta i}$. Les organigrammes des figures 9 et 10 représentent ensemble la succession des opérations à effectuer pour obtenir un couple de coefficients $\alpha$ et $\beta$ parmi les N coefficients $\alpha_i$ et $\beta_i$.

La figure 9 concerne principalement la détermination d'un coefficient $\beta$. Pour déterminer un nouveau coefficient $\beta(n + 1)$, on teste d'abord dans l'étape représentée par la case 100, si le signal $- e'$ et le gradient $G$ ont le même signe. Si ces signes sont différents, l'index $I_\beta$ relatif au coefficient $\beta$ doit augmenter: case 101. Dans la case 102, on teste si la valeur actuelle $I_\beta(n)$ de l'index est positive. Si oui, l'index est augmenté selon la formule de récurrence $I_\beta(n + 1) = I_\beta(n) + A_1$, $A_1$ étant une quantité positive: case 103; si non, l'index est augmenté selon la formule de récurrence $I_\beta(n + 1) = I_\beta(n) + C_1 - I_\beta(n)/B_1$, $B_1$ et $C_1$ étant des quantités positives. Dans les deux cas, on teste (case 105) si le nouvel index $I_\beta(n + 1)$ est plus élevé qu'une valeur maximale $I_{\beta max}$. Si la condition $I_\beta(n + 1) > I_{\beta max}$ est vérifiée, la nouvelle valeur de l'index retenue est $I_{\beta max}$: case 106; elle sert à lire dans la table 107, la valeur maximale du coefficient $\beta$. Si la condition $I_{\beta(n + 1)} > 1_{\beta max}$ n'est pas vérifiée, la nouvelle valeur de l'index $I_\beta(n + 1)$ est retenue et sert à lire directement dans la table 107 la nouvelle valeur $\beta(n + 1)$ du coefficient $\beta$. Si le test effectué dans la case 100 révèle que le signal $- e'$ et le gradient $G_\beta$ ont le même signe, l'index $I_\beta$ doit diminuer: case 108. Dans la case 109, on teste si la valeur actuelle $I_\beta(n)$ de l'index est négative. Si oui, l'index est diminué selon la formule de récurrence $I_\beta(n + 1) = I_\beta(n) - C_1$ case 110; si non, l'index est diminué selon la formule de récurrence $1_\beta(n + 1) = I_\beta(n) - A_1 - I_\beta(n)/D_1$, $D_1$ étant une quantité positive: case 111. Dans les deux cas, on teste (case 112) si le nouvel index $I_\beta(n + 1)$ est plus faible qu'une valeur minimale $I_{\beta min}$. Si $1_\beta(n + 1) < I_{\beta min}$ la nouvelle valeur de l'index retenue est $I_{\beta min}$: case 113;elle sert à lire dans la table 107, la valeur minimale du coefficient $\beta$. Si la condition $I_\beta(n + 1) < 1_{\beta min}$ n'est pas vérifiée, la nouvelle valeur de l'index $1_\beta(n + 1)$ est retenue et sert à lire directement dans la table 107 la nouvelle valeur $\beta(n + 1)$ du coefficient $\beta$.

Par ailleurs les conditions (2) de stabilité des cellules de filtrage montrent clairement qu'à chaque valeur d'un coefficient $\beta$ correspondent une valeur maximale et une valeur minimale du coefficient $\alpha$. De façon correspondante, à chaque valeur d'index $I_\beta$ utilisé pour la détermination du coefficient $\beta$, correspondent des valeurs maximales $I_{\alpha max}$ et minimale $I_{\alpha min}$ de l'index $I_\alpha$ utilisé pour la détermination du coefficient $\alpha$. La figure 9 montre donc les tables 114 et 115 dans lesquelles sont lues respectivement pour chaque valeur de l'index $I_\beta$, la valeur maximale $I_{\alpha max}$ et la valeur minimale $I_{\alpha min}$ de l'index $I_\alpha$.

L'organigramme de la figure 10 concerne la détermination d'un coefficient $\alpha$. Cet organigramme est sensiblement le même que celui de la figure 9 et dans les étapes représentées par les cases 120 à 133, on effectue des opérations identiques ou analogues à celles effectuées dans les étapes représentées par les cases 100 à 113 sur la figure 9. Dans la case 120, on teste si le signal $- e'$ et le gradient $G_\alpha$ ont le même signe, pour déterminer si l'index $I_\alpha$ doit croître (case 121) ou décroître (case 128). La suite des opérations est la même que sur l'organigramme de la figure 9, et aboutit à la lecture dans la table 127 des valeurs du coefficient $\alpha$, en fonction de valeurs retenues du nouvel index $I_\alpha(n + 1)$. Les formules de récurrence utilisées dans les cases 123, 124, 130 et 131 ont la même forme que celles utilisées dans les cases correspondantes 103, 104, 110 et 111, avec toutefois des quantités $E_1, F_1, G_1, H_1$ pouvant être différentes des quantités $A_1, 8_1, C_1, D_1$. On remarque d'autre part que dans les cases 125 et 132, où l'on teste les conditions $1_\alpha(n + 1) > I_{\alpha max}$ et $I_\alpha(n + 1) < I_{\alpha min}$, les valeurs $I_{\beta max}$ et $1_{\alpha max}$ ne sont pas fixes et proviennent des tables 114 et 115 représentées sur la figure 9.

On a supposé jusqu'à présent que toutes les cellules de filtrage en cascade composant le décodeur local du codeur et le décodeur distant étaient toutes de type récursif. On peut également utiliser des cellules de filtrage du type non récursif ou une combinaison de cellules de filtrage des deux types.

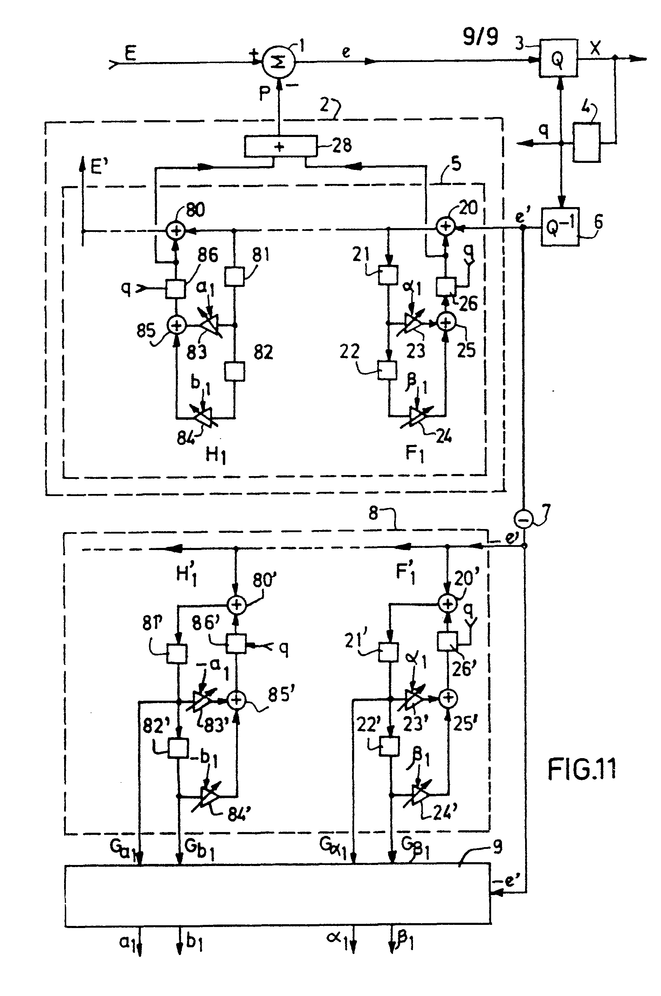

Sur la figure 11, on a représenté par exemple un codeur dont le filtre 5 par exemple est composé de N cellules récursives du second ordre, et de L cellules non récursives du second ordre. Les cellules récursives sont du même type que sur la figure 1, c'est-à-dire que leur fonction de transfert g(Z) répond à la formule (1). Pour simplifier, on n'a représenté que la première cellule $F_1$, dont les éléments sont munis des mêmes références que

14

sur la figure 1 et qui utilise deux coefficients variables $\alpha_1$ et $\beta_1$. Les cellules non récursives répondent à une fonction de transfert du type:

$$h(Z) = 1 + aZ^{-1} + bZ^{-2}$$

a et b étant les coefficients de ces cellules.

Pour simplifier on n'a représenté que la première cellule non récursive $H_1$ qui est composée d'un circuit additionneur 80 qui reçoit un signal d'entrée et un signal déduit du signal d'entrée au moyen des circuits de retard 81, 82, des circuits multiplicateurs par les coefficients variables $a_1$, $b_1$, du circuit additionneur 85 et du quantificateur d'arrondi 86. On peut remarquer ici que, comme cela est connu, on peut utiliser les mêmes circuits de retard pour des couples de cellules récursives et non récursives.

Comme on l'a déjà précisé, le signal de prédiction P est obtenu en formant, à l'aide du circuit additionneur 28 la somme de signaux provenant des cellules de filtrage en cascade; chacun de ces signaux est celui qui, dans chaque cellule (récursive ou non récursive) est ajouté au signal d'entrée de la cellule.

Tenant compte de la présence de L cellules non récursives utilisant les coefficients $a_1$ à $a_L$ et $b_1$ à $b_L$, on peut montrer que la formule (8) ci-dessus devient:

$$e = E \frac{(1 - \alpha_1 Z^{-1} - \beta_1 Z^{-2})(1 - \alpha_2 Z^{-1} - \beta_2 Z^{-2})\dots(1 - \alpha_N Z^{-1} - \beta_N Z^{-2})}{(1 + a_1 Z^{-1} + b_1 Z^{-2})(1 + a_2 Z^{-1} + b_2 Z^{-2})\dots(1 + a_L Z^{-1} + b_L Z^{-2})} \qquad (21)$$

les coefficients $\alpha_i$ et $\beta_i$ $(1 \leqslant i \leqslant N)$ étant ceux des cellules récursives, les coefficients $a_j$ et $b_j$ $(1 \leqslant j \leqslant L)$ étant ceux des cellules non récursives.

On peut montrer que les gradients

$$G_{\alpha i} = \frac{\partial e}{\partial \alpha i} \quad \text{et } G_{\beta i} = \frac{\partial e}{\partial \beta i}$$

répondent aux formules (9) et (10) données plus haut et que les gradients

$$G_{aj} = \frac{\partial e}{\partial aj} \quad \text{et} \quad G_{bj} = \frac{\partial e}{\partial bj}$$

répondent aux formules:

$$G_{aj} = \frac{- e(Z^{-1})}{1 + a_j Z^{-1} + b_j Z^{-2}} \qquad (22)$$

$$G_{bj} = \frac{- e(Z^{-2})}{1 + a_j Z^{-1} + b_j Z^{-2}} \qquad (23)$$

Les formules (22) et (23) montrent que les gradients $G_{aj}$ et $G_{bj}$ correspondant aux cellules non récursives peuvent êtreobtenus en appliquant le signal - e à des cellules récursives à fonction de transfert inverse de celle des cellules non récursives, et en prélevant les signaux aux endroits de ces cellules récursives, où le signal de sortie de ces cellules est retardé de T et 2T.

Sur la figure 11, il est montré comment sont calculés dans le circuit 8 les gradients $G_{\alpha j}$ et $G_{\beta j}$, relatifs aux coefficients $\alpha_1$ et $\beta_1$ de la cellule $F_1$ et les gradients $G_{1}$ et $G_{b1}$ relatifs aux coefficients $a_1$ et $b_1$ de la cellule $H_1$. Les gradients $G_{\alpha 1}$ et $G_{\beta 1}$ sont obtenus exactement comme sur la figure 1 en appliquant le signal - e' à une cellule $F'_1$ identique à la cellule $F_1$ et en prélevant les signauxaux mêmes endroits, aux sorties des circuits de retard 2l'et 22'. Les gradients $G_{a1}$ et $G_{b1}$ sont obtenus en appliquant le signal - e' à une cellule récursive $H'_1$ à fonction de transfert inverse de la cellule $H_1$.Cet-te cellule $H'_1$ comporte des éléments 81' à 86' ayant la même fonction que les éléments 81 à 86 de la cellule $H_1$ et branchés de la mêmemanière, à la différence près que l'entrée du circuit de retard 8l'est connectée à la sortie du circuit additionneur 80' et que les coefficients utilisés dans les circuits multiplicateurs 83', 84' sont les coefficients $a_1$ et $b_1$ changés de signe. Les gradients $G_{a1}$ et $G_{b1}$ sont disponibles à la sortie des circuits de retard 8l'et 82'.

Les coefficients $\alpha_i$, $\beta_i$ sont réglés dans le dispositif 9 en utilisant les formules de récurrence (5) et (6); les coefficients $a_j$ et $b_j$ sont réglés également au moyen des formules de récurrence (5) et (6) dans lesquelles sont utilisés les gradients $G_{aj}$ et $G_{bj}$. Le dispositif de réglage 9 des coefficients peut être exactement semblable à celui de la figure 5, sans que l'on distingue entre les coefficients $\alpha_i$, $\beta_i$ et $a_j$, $b_j$.

On pourrait également utiliser dans le filtre 5 du codeur, des cellules non récursives du deuxième ordre ayant une fonction de transfert h"(Z) de la forme:

$$h''(Z) = 1 + b(dZ^{-1} + Z^{-2}) \quad (24)$$

On peut utiliser ces cellules non récursives à fonction de transfert h"(Z) en cascade avec les cellules récursives ayant la fonction de transfert g'(Z) de la formule (11). Aux cellules non récursives du filtre 5, à fonction de transfert h"(Z) avec un coefficient variable $b_j$. et un coefficient fixe $d_j$, on peut faire correspondre des cellules de calcul du gradient à fonction de transfert

$$\frac{1}{h'(Z)}$$

avec un coefficient variable $b_j$ et un coefficient fixe $d_j$. Dans une autre variante, on peut faire correspondre à ces cellules non récursives du filtre 5 à coefficients $b_j$ variable et $d_j$ fixe des cellules de calcul du gradient approché à fonction de transfert

$$\frac{1}{h''(Z)} = \frac{1}{1 + c_j(d_jZ^{-1} + Z^{-2})},$$

$c_j$ et $d_j$ étant des coefficients fixes. Dans ces deux variantes le gradient $G_{bj}$ est obtenu en prélevant le signal à l'endroit de la cellule de calcul de gradient où le signal de sortie est multiplié par $(dZ^{-1} + Z^{-2})$. Les coefficients des cellules non récursives peuvent être déterminés à partir des signes du signal - e' et des gradients, de la même manière que les coefficients des cellules récursives, en utilisant en particulier un index, comme on l'a expliqué au moyen des figures 8, 9, 10.

## 0 078 581

**Revendications:**

1. Système de transmission numérique d'informations utilisant la modulation différentielle par codage d'impulsions et comportant un codeur destiné à convertir un signal MIC linéaire entrant (E) en un signal MIC différentiel (X) et un décodeur distant destiné à effectuer la conversion inverse, le codeur comportant un circuit de différence (1) formant le signal de différence (e) entre le signal MIC linéaire entrant (E) et un signal de prédiction (P), un quantificateur (3) quantifiant le signal de différence pour former le signal MIC différentiel et enfin un décodeur local (4, 5, 6) recevant le signal MIC différentiel et servant à former le signal de prédiction, le décodeur local et le décodeur distant (14, 15, 16) étant constitués de la même manière et comportant un quantificateur (6), (16) inverse du quantificateur précité (3) et un filtre (5) (15) formé d'une ou plusieurs cellules de filtrage ($F_1$ - $F_N$) en cascade du deuxième ordre à deux coefficients et à fonction de transfert réglable, chaque coefficient réglagle desdites cellules de filtrage étant calculé par récurrences sucessives, le terme de modification de chaque coefficient réglable étant calculé à chaque récurrence à partir du produit du signal (e') sortant dudit quantificateur inverse (6), (16), et du gradient dudit signal de différence vis à vis dudit coefficient réglable, des moyens étant prévus pour tester si, pour chaque cellule et à chaque récurrence, chaque coefficient réglable affecté d'un terme de modification calculé est plus élevé qu'une valeur limite supérieure ou plus faible qu'une valeur limite inférieure, ces valeurs limites étant déterminées pour que les pôles (ou les racines) de la fonction de transfert en Z de ladite cellule soient juste à l'intérieur du cercle de rayon unité, caractérisé en ce que chaque cellule de filtrage est du type récursif ($F_{1a}$), répondant à la fonction de transfert en Z, $g'(Z) = 1/1 - \beta (\delta z^{-1} + z^{-2})$ ou du type non récursif répondant à la fonction de transfert en Z $h'(Z) = 1 + b (dZ^{-1} + Z^{-2})$ $\beta$ et b étant des coefficients reglables, $\delta$ et d étant des coefficients fixes, le gradient $G_\beta$ (ou $G_b$) étant obtenu en appliquant le signal (e') sortant dudit quantificateur inverse (6),(16) à une cellule de calcul de gradient récursive ($F'_{1a}$) répondant à la fonction de transfert $g'(Z)$ (ou $\dfrac{1}{h'(Z)}$)

avec un coefficient fixe $\delta$ (ou d) approximativement égal à celui de la cellule correspondante des filtres du décodeur local et du décodeur distant, le gradient $G\beta$ (ou $G_b$) étant prélevé en un endroit de la cellule de calcul de gradient où le signal de sortie de cette cellule est multiplié par la fonction de Z, $\delta Z^{-1} + Z^{-2}$ (ou $dZ^{-1} + Z^{-2}$).

2. Système de transmission selon la revendication 1, caractérisé en ce que, dans les cellules de calcul de gradient ($F'_{1a}$ - $F'_{Na}$), le coefficient $\beta$ (ou b) est maintenu à une valeur fixe $\gamma$ (ou c).

3. Système de transmission selon l'une des revendications 1 et 2, caractérisé en ce que, dans le codeur, le signal de prédiction (P) est obtenu en formant la somme de signaux prelevés dans lesdites cellules de filtrage ($F_{1a}$ - $F_{Na}$), chacun de ces signaux étant celui qui, dans chaque cellule de filtrage, est ajouté au signal d'entrée de la cellule.

4. Système de transmission selon l'une des revendications 1 à 3, dans lequel les cellules de filtrage ($F_{1a}$- $F_{Na}$) sont munies d'un dispositif (46) d'arrondi (ou de troncation) avec un pas égal à l'échelon de quantification (q) du MIC différentiel, caractérisé en ce que les cellules de calcul de gradient ($F'_{1a}$ - $F'_{Na}$) sont munies d'un dispositif (46') d'arrondi (ou de troncation) avec un pas égal à l'échelon de quantification (q) du MIC différentiel.

5. Système de transmission selon l'une des revendications 1 à 4, caractérisé en ce que, pour chaque cellule de filtrage répondant à la fonction de transfert en Z, $g''(Z)$ (ou $h''(Z)$), lesdites valeurs limites utilisées à chaque récurrence pour le test du coefficient réglable $\beta$ ou b, sont déduites des conditions

$$|\beta| < 1 \text{ et } |\delta| < \frac{|1 - \beta|}{|\beta|} \text{ ou } \left(|b| 1 \text{ et } |d| < \frac{|1 - b|}{|b|}\right),$$

que doit respecter le coefficient réglable $\beta$ ou b, pour que les pôles de la fonction $g'(Z)$ ou les racines de la fonction $h,(Z)$ soient à l'intérieur du cercle de rayon unité.

6. Système de transmission selon la revendication 5, caractérisé en ce que les coefficients fixes $\delta$ (ou d) des cellules de filtrage à fonction de transfert $g'(Z)$ (ou $h'(Z)$) sont choisis de sorte que $-2 \leqslant \delta \leqslant 2$ (ou $-2 \leqslant d \leqslant 2$), lesdites valeurs limites utilisées à chaque récurrence pour le test du coefficient réglable $\beta$ (ou b) étant alors déduites des conditions $-1 < \beta \leqslant 0$ (ou $-1 < b \leqslant 0$).

7. Système de transmission selon l'une des revendications 1 à 6, caractérisé en ce que pour chaque coefficient

17

réglable le dispositif de réglage des coefficients (52), (152) comporte des moyens répondant aux signes du gradient et dudit signal déduit du signal MIC différentiel pour déterminer à chaque récurrence le sens de variation de chaque coefficient réglable.

8. Système de transmission selon la revendication 7, caractérisé en ce que le dispositif de réglage des coefficients comporte en outre des moyens pour calculer une variable auxiliaire I correspondant à chaque coefficient réglable, selon des formules de récurrence dépendant à chaque récurrence du signe actuel de ladite variable auxiliaire et dudit sens de variation de chaque coefficient réglable, enfin des moyens de lecture dans une table des valeurs de chaque coefficient réglable en fonction des valeurs de la variable auxiliaire.

9. Système de transmission selon la revendication 8, caractérisé en ce que, lorsqu'un coefficient réglable doit croitre, la variable auxiliaire correspondante I est calculée selon la formule de récurrence $I(n + 1) = I(n) + A$ ou

$$I(n+1) = I(n) + C - \frac{I(n)}{B}$$

selon que la valeur actuelle $I(n)$ est positive ou non et lorsqu'un coefficient réglable doit de croitre, la variable auxiliaire correspondante I est calculée selon la formule de récurrence $I(n + 1) = I(n) - C$ ou $I(n + 1) = I(n) - A - \frac{I(n)}{D}$

selon que la valeur actuelle $I(n)$ est négative ou non, A,D B, C et D étant des quantités constantes positives.

10. Système de transmission selon l'une des revendications 8 ou 9, caractérisé en ce que le test à effectuer a chaque récurrence sur chaque coefficient réglable de chaque cellule de filtrage est effectué sur la variable auxiliaire correspondant audit coefficient réglable, les valeurs limites de la variable auxiliaire utilisées pour ce test étant déduites desdites valeurs limites déterminées pour le coefficient réglable.

**Patentansprüche:**

1. Digitales Informationsübertragungssystem mit Anwendung differentieller Pulscodemodulation und mit einem Codierer zum Umwandeln eines eintreffenden linearen PCM-Signals (E) in ein differentielles PCM-Signal (X) sowie einem fernen Decodierer zum Durchführen der inversen Umwandlung, wobei der Codierer eine Differenzschaltung (1) aufweist, die das Differenzsignal (e) zwischen dem eintreffenden linearen PCM-Signal (E) und einem Prädiktionssignal (P) bildet, eine Quantisierschaltung (3), die das Differenzsignal quantisiert zum Bilden des differentiellen PCM-signals und zum Schluss einen lokalen Decodierer (4, 5, 6), der das differentielle PCM-Signal erhält und das Prädiktionssignal bildet, wobei der lokale becodierer und der ferne Decodierer (14, 15, 16) auf dieselbe Art und Weise ausgebildet sind und eine zur genannten Quantisierschaltung (3) inverse Quantisierschaltung (6), (16) auf eisen und ein Filter (5), (15), gebildet durch eine Reihenschaltung aus einer oder mehreren Filterzellen zweiter Ordnung (F - F) mit zwei Koeffizienten und mit einer regelbaren Übertragungsfunktion, wobei jeder regelbare Koeffizient der genannten Filterzellen nach einem Iterationsverfahren berechnet wird, wobei der Änderungsterm jedes regelbaren Koeffizienten bei jedem Iterationsschritt aus dem Produkt des von der genannten inversen Quantisierschaltung (6), (16) herrührenden Signals (e') und dem Gradienten des genannten Differenzsignals in bezug auf den genannten regelbaren Koeffizienten berechnet wird, wobei Mittel vorgesehen sind zum Uberprüfen ob, für jede Zelle und für jeden Iterationsschritt, jeder durch einen berechneten Änderungsterm beeinflusste regelbare Koeffizient grösser ist als ein oberer Grenzwert oder kleiner ist als ein unterer Grenzwert, wobei diese Grenzwerte derart bestimmt sind, dass die Pole (oder die Wurzeln) der Übertragungsfunktion im Z-Bereich für die genannte Zelle gerade innerhalb des Einheitskreises liegen, dadurch gekennzeichnet, dass jede Filterzelle vom rekursiven Typ ist $(F_{1a})$ entsprechend der Übertragungsfunktion im Z-Bereich $g'(Z) = 1/1 - \beta (\delta Z^{-1} + Z^{-1})$ oder vom nicht-rekursiven Typ entsprechend der Übertragungsfunktion im Z-Bereich $h'(Z) = 1 + b(dZ^{-1} + Z^{-2})$, wobei $\beta$ und b regelbare Koeffizienten sind, $\delta$ und d feste Koeffizienten sind, und der Gradient $G \beta$ (oder $G_b$) dadurch erhalten wird, dass das von der genannten inversen Quantisierschaltung (6), (16) herrührende Signal (e') einer rekursiven Gradientenberechnungszelle $(F'_{1a})$ zugeführt wird, die der Übertragungsfunktion $g'(Z)$ (oder $\frac{1}{h'(Z)}$ )

mit einem festen Koeffizienten $\delta$ (oder d) nahezu gleich dem der entsprechenden Filterzelle des lokalen Decodierers und des fernen Decodierers entspricht, wobei der genannte Gradient $G \delta$ (oder $G_b$) an einer Stelle der Gradientenberechnungszelle entnommen wird, wo das Ausgangssignal dieser Zelle durch die Funktion im Z-Bereich $\delta Z^{-1} + Z^{-2}$ (oder $dZ^{-2} + Z^{-2}$) multipliziert worden ist.

2. Übertragungssystem nach Anspruch 1, dadurch gekennzeichnet, dass in den Gradientenberechnungszellen ($F'_{1a}$ - $F'_{Na}$) der Koeffizient $\beta$ (oder b) auf einem festen (Wert $\delta$ (oder c) gehalten wird.

3. Übertragungssystem nach einem der Ansprüche 1 und 2, dadurch gekennzeichnet, dass in dem Codierer das Prädiktionssignal (P) dadurch erhalten wird, dass die Summe der den genannten Filterzellen ($F_{1a}$ - $F_{Na}$) entnommenen Signale gebildet wird, wobei jedes dieser Signale das Signal ist, das in jeder Filterzelle zu dem Eingangssignal der Zelle addiert wird.

4. Übertragungssystem nach einem der Ansprüche 1 bis 3, wobei die Filterzellen ($F_{1a}$ - $F_{Na}$) mit einer Rundungs- (oder Abschneidungs-) Anordnung (46) versehen sind, die mit einem Schritt entsprechend dem Quantisierungsschritt (q) des differentiellen PCM-Signals arbeitet, dadurch gekennzeichnet, dass die Gradientenberechnungszellen ($F'_{1a}$ - $F'_{Na}$) mit einer Rundungs- (oder Abschneidungs)anordnung (46') versehen sind, die mit einem Schritt entsprechend dem Quantisierungsschritt (q) des differentiellen PCM-Signals arbeitet.

5. Übertragungssystem nach einem der Ansprüche 1 bis 4, dadurch gekennzeichnet, dass für jede Filterzelle, die der Übertragungsfunktion im Z-Bereich g'(Z) (oder h'(Z)) entspricht, die genannten bei jedem Iterationsschritt zur Überprüfung des regelbaren Koeffizienten $\beta$ oder b verwendeten Grenzwerte abgeleitet werden von den Bedingungen

$$\left| \beta \right| < 1 \text{ und } \left| \delta \right| < \frac{\left| 1 - \beta \right|}{\left| \beta \right|} \text{ oder } \left( \left| b \right| < 1 \text{ und } \left| d \right| < \frac{\left| 1 - b \right|}{\left| b \right|} \right),$$

welchen die regelbaren Koeffizienten $\beta$ oder b entsprechen sollen um zu gewährleisten, dass die Pole der Funktion g'(Z) oder die Wurzeln der Funktion h'(Z) gerade innerhalb des Einheitskreises liegen.

6. Übertragungssystem nach Anspruch 5, dadurch gekennzeichnet, dass die festen Koeffizienten $\delta$ (oder d) der Filterzellen mit der Übertragungsfunktion g'(Z) (oder h'(Z)) derart gewählt sind, dass $-2 \leqslant \delta \leqslant 2$ (oder $-2 \leqslant d \leqslant 2$) ist, wobei die genannten bei jedem Iterationsschritt zur Überprüfung des regelbaren Koeffizienten $\beta$ (oder b) verwendeten Grenzwerte von den Bedingungen $-1 < \beta \leqslant 0$ (oder $-1 < b \leqslant 0$) abgeleitet werden.

7. Übertragungssystem nach einem der Ansprüche 1 bis 6, dadurch gekennzeichnet, dass für jeden regelbaren Koeffizienten die Koeffizientenregelanordnung (52), (152) Mittel aufweist, die bei jedem Iterationsschritt die Änderungsrichtung jedes regelbaren Koeffizienten entsprechend den Vorzeichen des Gradienten und des genannten vom differentiellen PCM-Signal abgeleiteten Signals bestimmen.

8. Übertragungssystem nach Anspruch 7, dadurch gekennzeichnet, dass die Koeffizientenregelanordnung weiterhin Mittel aufweist zum Berechnen einer zusätzlichen, jedem regelbaren Koeffizienten zugehörigen Veränderlichen I entsprechend Rekursionsformeln, die bei jedem Iterationsschritt von dem aktuellen Vorzeichen des genannten zusätzlichen Veränderlichen und von der genannten Änderungsrichtung jedes regelbaren Koeffizienten abhängig sind, und zum Schluss Mittel zum aus einer Tafel Auslesen von Werten jedes regelbaren Koeffizienten als Funktion von Werten der zusätzlichen Veränderlichen.

9. Übertragungssystem nach Anspruch 8, dadurch gekennzeichnet, dass wenn ein regelbarer Koeffizient zunehmen soll, die entsprechende zusätzliche Veränderliche I entsprechend der Rekursionsformel $I(n+1) = I(n)$

$+ A$ oder $I(n+1) = I(n) + C \cdot \dfrac{I(n)}{B}$

19

0 078 581

FIG55/15

berechnet wird, je nachdem der Istwert I(n) positiv ist oder nicht, und wenn ein regelbarer Koeffizient abnehmen soll, die entsprechende zusätzliche Veränderliche I entsprechend der Rekursionsformel $I(n+1) = I(n)$ - C oder $I(n+1) = I(n) - A - \dfrac{I(n)}{D}$ berechnet wird, je nachdem der Istwert I(n) negativ ist oder nicht, wobei A, B, C und D konstante positive Grössen sind.

10. Übertragungssystem nach einem der Ansprüche 8 oder 9, dadurch gekennzeichnet, dass die bei jedem Iterationsschritt an jedem regelbaren Koeffizienten jeder Filterzelle durchzuführende Überprüfung an der zusätzlichen, dem genannten regelbaren Koeffizienten zugehörigen Veränderlichen durchgeführt wird, wobei die für diese Überprüfung benutzten Grenzwerte der zusätzlichen Veränderlichen aus den genannten für den regelbaren Koeffizienten bestimmten Grenzwerten abgeleitet werden.

**Claims:**

1. A digital information transmission system using differential pulse code modulation and comprising an encoder for converting an incoming linear PCM signal (E) into a dif ferential PCM signal (X) and a remote decoder for carrying out the inverse conversion, the encoder comprising a dif f erence circuit (1) forming the difference signal (e) between the incoming linear PCM signal (E) and a prediction signal (P), a quantizer (3) quantizing the difference signal to form the differential PCM signal and finally a local decoder (4,5, 6) receiving the dif ferential PCM signal and forming the prediction signal, the local decoder and the remote decoder (14, 15, 16) being constituted in the same manner and comprising a quantizer (6), (16) operating inversely to said quantizer (3) and a filter (5), (15) constituted by one or several cascade-arranged second-order filtering sections $(F_1 - F_N)$ having two coefficients and a controllable transfer function, each controllable coefficient of said filtering sections being calculated by successive iterations, the modification term of each controllable coef ficient being calculated at each iteration from the product of the signal (e') supplied by said inverse quantizer (6), (16), and the gradient of said dif ference signal with respect to said controllable coef f icient, means being provided for testing, for each section and each iteration, whether each controllable coef f icient af fected by a calculated modification term is larger than an upper limit value or smaller than a lower limit value, these limits values being determined so that the poles (or the zeros) of the transfer function in Z of each said section lie just inside the circle of unit radius, characterized in that each f iltering section is of the recursive type $(F_{1a})$, answering to a transfer function in Z of the type $g'(Z) = 1/1 - \beta (\delta Z^{-1} + Z^{-2})$, or of the non-recursivetype answering to the transfer function in Z of the type $h'(Z) = 1 + b(dZ^{-1} + Z^{-2})$, $\beta$ and b being controllable coefficients, $\delta$ and d being fixed coefficients, the gradient GF (or $G_b$) being obtained by applying the signal (e') supplied by said inverse quantizer (6), (16) to a recursive gradient calculation section $(F'_{1a})$ answering to the transfer function $g'(Z)$ (or $\dfrac{1}{h'(Z)}$ )

with a fixed coef ficient $\delta$ (or d) approximately equal to that of the corresponding filtering sections of the local decoder and the remote decoder, said gradient $G_\beta$ (or $G_b$) being derived at a node of the gradient calculation section where the output signal of this section is multiplied by the function in Z of the type $\delta Z^{-1} + Z^{-2}$ (or $dZ^{-1} + Z^{-2}$).

2. A transmission system as claimed in claim 1, characterized in that in the gradient calculation section $(F'_{1a} - F'_{Na})$, the coefficient $\beta$ (or b) is kept at a fixed value $\gamma$ (or c).

3. A transmission system as claimed in either one of the claims 1 and 2, characterized in that the prediction signal (P) in the encoder is obtained by forming the sum of the signals derived in said filtering sections $(F_{1a} - F_{Na})$, each of these signals being the signal which, in each filtering section, is added to the input signal of the section.

4. A transmission system as claimed in any one of the claims 1 to 3, in which the filtering sections $(F_{1a} - F_{Na})$ are provided with a round off (or truncation) circuit (46) operating with a step equal to the quantizing step (q) of the differential PCM signal, characterized in that the gradient calculation sections $(F'_{1a} F'_{Na})$ are provided with a round off (or truncation) arrangement (46,) operating with a step equal to the quantizing step (q) of the dif ferential PCM signal.

5. A transmission system as claimed in any one of the claims 1 to 4, characterized in that, for each f iltering section answering to the transfer function in Z, g' (Z) (or h' (Z)), said limit values used at each iteration for the test of the controllable coefficient $\beta$ or b, are derived from the conditions

$$|\beta| < 1 \text{ and } |\delta| < \frac{|1 - \beta|}{|\beta|} \text{ (or } |b| < 1 \text{ and } |d| < \frac{|1 - b|}{|b|} \text{)},$$

0 078 581

which the controllable coefficients β or b have to satisfy in order that the poles of the function g' (Z) or the zeros of the function h' (Z) lie inside the circle of unit radius.

6. A transmission system as claimed in claim 5, characterized in that the fixed coef f icients δ (or d) of the f iltering sections having the transfer function g' (Z) (or h' (Z)) are chosen such that $-2 < \delta \leqslant 2$ (or $-2 < d < 2$), said limit values utilized at each iteration for testing the controllable coef f icient β (or b) then being derived from the conditions $-1 < \beta \leqslant 0$ (or $-1 < b \leqslant 0$)

7. A transmission system as claimed in any one of the claims 1 to 6, characterized in that for each controllable coef ficient the coef ficients controlling circuit (52), (152) comprises means responsive to the signs of the gradient and of said signal derived from the differential PCM signal for determining at each iteration the sense of variation of each controllable coef ficient.

8. A transmission system as claimed in claim 7, characterized in that the the coefficients controlling circuit further comprises means for calculating an auxiliary variable 1 corresponding to each controllable coefficient in accordance with the iteration formulae, which at each iteration depends on the actual sign of said auxiliary variable and on said sense of variation of each controllable coef ficient, and finally means for reading f rom a table the values of each controllable coef ficient as a function of the values of the auxiliary variable.

9. A transmission system as claimed in claim 8, characterized in that, when a controllable coef ficient has to increase, the corresponding auxiliary variable I is calculated according to the iteration formula $I(n + 1) = I(n) - A$ or $I(n + 1) = I(n) + C - I(n)/B$ according as the actual value $I(n)$ is positive or not, and when a controllable coefficient has to decrease, the corresponding auxiliary variable I is calculated according to the iteration formula $I(n + 1) = I(n) - C$ or $I(n + 1) = I(n) - A - I(n)/D$ according as the actual value $I(n)$ is negative or not, A, B, C and D being constant positive quantities.

10. A transmission system as claimed in either one of the claims 8 or 9, characterized in that the test to be performed at each iteration on each controllable coefficient of each filtering section is performed on the auxiliary variable corresponding to said controllable coefficient, the limit values of the auxiliary variable utilized for this test being derived f rom said limit values determined for the controllable coefficient.

21

FIG.1

FIG.2

FIG.3

FIG.4

5

FIG.5

FIG.6

0 078 581

FIG.7

$$I(n+1) = I(n) + A$$

$$I(n+1) = I(n) - A - \frac{I(n)}{}$$

$$I(n+1) > I_{max}$$

$$I(n+1) < 0$$

$$I(n+1) = I_{max}$$

$$I(n+1) = 0$$

FIG.8

FIG.9

7/9

$G_\alpha$ ╴120

Sgn $G_\alpha$ = Sgn(−e') — 120

− e'

$I_\alpha$ ↗ — 121

$I_\alpha$ ↘ — 128

$I_\alpha(n) > 0$ — 122

$I_\alpha(n) < 0$ — 129

123 — $I_\alpha(n+1) = I_\alpha(n) + E_1$

124 — $I_\alpha(n+1) = I_\alpha(n) + G_1 - I_\alpha(n)/F_1$

130 — $I_\alpha(n+1) = I_\alpha(n) - G_1$

131 — $I_\alpha(n+1) = I_\alpha(n) - E_1 - I_\alpha(n)/H_1$

$I_\alpha(n+1) > I_\alpha max$ — 125

$I_\alpha(n+1) < I_\alpha min$ — 132

$I_\alpha max$

$I_\alpha(n+1) = I_\alpha max$ — 126

$I_\alpha min$

$I_\alpha(n+1) = I_\alpha min$ — 133

$\alpha = f(I_\alpha)$ — 127

$\alpha$

FIG.10

0 078 581

FIG.11